# EUROPEAN PATENT SPECIFICATION

(11) **EP 2 224 590 B1**
(45) Date of publication and mention of the grant of the patent: **04.05.2011**
(21) Application number: 09290134.7
(22) Date of filing: 25.02.2009
(51) Int. Cl.: H03F 1/56, H03F 3/60, H03H 7/38, H01P 1/213, H01L 23/66, H04B 1/38, H03F 3/24

(54) **Power amplification for fragmented transceiver systems**
Leistungsverstärkung für fragmentierte Transceiversysteme
Amplification de puissance pour systèmes émetteurs-récepteurs fragmentés

(43) Date of publication of application: 01.09.2010
(73) Proprietor: Alcatel Lucent, 75008 Paris (FR)
(72) Inventor: Pascht, Andreas, 73614 Schorndorf (DE); Wiegner, Dirk, 71409 Schwaikheim (DE)
(74) Representative: Schmidt, Werner Karl

(56) References cited:
- EP-A- 0 744 831
- EP-A- 1 885 058
- EP-A- 1 936 814
- EP-A1- 1 916 772
- US-B1- 6 970 040
- TORIKKA T ET AL: "Chip-package co-design of a concurrent LNA in system-on-package for multi-band radio applications" ELECTRONIC COMPONENTS AND TECHNOLOGY, 2004. ECTC '04. PROCEEDINGS LAS VEGAS, NV, USA JUNE 1-4, 2004, PISCATAWAY, NJ, USA,IEEE, vol. 2, 1 June 2004 (2004-06-01), pages 1687-1692, XP010715296 ISBN: 978-0-7803-8365-4
- INGRUBER B ET AL: "HIGH EFFICIENCY HARMONIC CONTROL AMPLIFIER" 1996 IEEE MTT-S INTERNATIONAL MICROWAVE SYMPOSIUM DIGEST. SAN FRANCISCO, JUNE 17 - 21, 1996; [IEEE MTT-S INTERNATIONAL MICROWAVE SYMPOSIUM DIGEST], NEW YORK, IEEE, UI, 17 June 1996 (1996-06-17), pages 859-862, XP000731991 ISBN: 978-0-7803-3247-8
- MAXIM INTEGRATED PRODUCTS: "Designing with the MAX2648 5GHz LNA for High-Frequency Stability", INTERNET CITATION, 27 September 2002 (2002-09-27), pages 1-6, XP007913435, Retrieved from the Internet: URL:http://pdfserv.maxim-ic.com/en/an/AN17 56.pdf [retrieved on 2010-06-10]

## Description

### Field of the Invention

This invention relates to power amplification for fragmented transceiver systems, in particular to an arrangement and a method for amplification of an RF signal having a plurality of different wavelengths, a base station for a cellular communication network comprising the amplifier arrangement and a communication network of a cellular communication system comprising the amplifier arrangement.

### Description of Related Art

In fragmented transceiver systems the available frequency slots for a provider are fragmented over the frequency bandwidth. Presently existing multi-band power amplifiers do not offer an appropriate matching architecture for use of the fragmented frequency slots in an efficient manner.

EP 1 916 772 A1 discloses a matching circuit and multi-band amplifier having the features of the preamble of claims 1.

The article "Designing with the MAX2648 5GHz LNA for High-Frequency Stability", application note 1756, pages 1-6, retrieved from URL "http://pdfserv.maxim-ic.com/en/an/AN1756.pdf", discloses RF input and output matching networks using a microstrip capacitive element as part of output matching in order to assure stable operation of the MAX2648 at all frequencies.

"Chip-Package Co-Design of a Concurrent LNA in System-on-Package for Multi-Band Radio Applications" by T. Torikka et al., ECTC '04, Proceedings, IEEE, vol. 2, pages 1687-1692, discloses a system-on-package module for multi-band radio transceivers which consists of a wideband LNA and a multi-band pass filter. The module is implemented with embedded chip technologies for system-on-package and is implemented on a liquid crystal polymer substrate.

### Summary of the Invention

In view of the above, the object of the present invention is to create an amplifier arrangement as well as an amplification method of an RF signal having a plurality of different wavelengths, said amplifier arrangement and amplification method being devised for synchronous operation of different standards in different frequency bands and can provide a solution for flexible frequency and load management for different standards as well as provide a flexible configuration of selectable frequency bands by optionally matching RF signal input and output lines.

According to a first important aspect, the invention provides an amplifier arrangement adapted for amplification of an RF input signal having a plurality of different wavelengths and being input through different input lines either serially or in parallel, said amplifier arrangement comprising an RF broadband amplifier component having an input terminal and an output terminal, a common RF signal input line being arranged for receiving said RF input signal and branching into a plurality of single RF signal input matching lines connected in common to the input terminal of said RF amplifier component, and each single RF signal input matching line forming an RF signal input matching network configured for matching said single RF signal input matching line to at least one of said wavelengths travelling through said single RF signal input matching line, wherein each single RF signal input matching line at its branching point and at its connection to the input terminal of said RF amplifier is respectively coupled to λ/4 blocking means for blocking against one or more wavelengths of said RF input signal to which said respective RF signal input matching line is not matched; and a plurality of RF signal output matching lines being connected in common to the output terminal of said amplifier component, and each single RF signal output matching line forming an RF signal output matching network configured for matching said single RF signal output matching line to at least one of said wavelengths travelling through said single RF signal output matching line, and the plurality of the RF signal output matching lines being connected together at their ends opposite to said output terminal of said RF amplifier component to become a common RF signal output line for outputting the amplified RF output signal having said plurality of different wavelengths, wherein each single RF signal output matching line at its at its connection point to the output terminal of said RF amplifier and at its connection point to the other RF signal output matching lines is respectively coupled to λ/4 blocking means for blocking against one or more wavelengths of said RF output signal to which said respective RF signal output line is not matched.

In the present amplifier arrangement, the A/4 blocking means are each configured as a capacitive line branching to ground and adapted in the capacity for short-circuiting said at least one wavelength of said RF input and output signal, respectively, against which the respective RF signal input and output matching lines are blocked.

Further in the present amplifier arrangement, said RF broadband amplifier component is implemented as a transistor having a strip line-compatible configuration with terminal lugs as the RF input and output terminals, respectively, and said plurality of branched single RF signal input matching lines and said plurality of single RF signal output matching lines are each configured as strip lines on a supporting substrate.

In case a width of said plurality of RF signal input matching lines in a lateral direction of said supporting substrate is equal to or smaller than a lateral width of said RF input terminal lug of said transistor, the plural RF signal input matching lines are arranged side by side in the lateral direction on a common layer of the supporting substrate and are connected side by side to said input terminal lug.

If otherwise a width of said RF signal input matching lines in a lateral direction of said supporting substrate is greater than a lateral width of said RF input terminal lug of said transistor, the plural RF signal input matching lines are arranged in a vertically stacked manner in different layers of the supporting substrate and connected vertically to said input terminal lug.

Further, in case a width of said plurality of RF signal output matching lines in a lateral direction of said supporting substrate is equal to or smaller than a lateral width of said RF output terminal lug of said transistor, these output matching lines are arranged side by side in the lateral direction on a common layer of the supporting substrate and are connected side by side to said output terminal lug.

If otherwise a width of said plurality of RF signal output matching lines in a lateral direction of said supporting substrate is greater than a lateral width of said RF output terminal lug of said transistor, the plural RF signal output matching lines are stacked in the vertical direction in different layers of the supporting substrate and vertically connected to said output terminal lug.

According to one embodiment of the present amplifier arrangement said RF input signal has a first and second wavelength, a first and a second RF signal input matching line and a first and a second RF signal output matching line are respectively provided, each single RF signal input matching line being respectively coupled to two associated λ/4 blocking means each configured for blocking the respective RF signal input line against one of said first and second wavelengths of the RF input signal to which the respective RF signal input matching line is not matched, and each single RF signal output matching line being respectively coupled to two associated λ/4 blocking means each configured for blocking the respective RF signal output line against one of said first and second wavelengths of the RF output signal to which said respective RF signal output matching line is not matched.

According to a further embodiment said RF input signal has three different wavelengths, said plurality of branched single RF signal input matching lines includes a first, second and third RF signal input matching line and said plurality of RF signal output matching lines includes a first, second and third RF signal output matching line, two first and two second λ/4 blocking means are coupled to said first RF signal input matching line and configured for blocking against the second and third wavelength of said wavelengths of said RF input signal, two third and two fourth λ/4 blocking means are coupled to said second RF signal input matching line and configured for blocking against the first and third wavelength of said wavelengths of said RF input signal, two fifth and two sixth λ/4 blocking means are coupled to said third RF signal input line and configured for blocking against the first and second wavelength of said wavelengths of said RF input signal, two first and two second λ/4 blocking means are coupled to said first RF signal output matching line and configured for blocking against the second and third wavelength of said wavelengths of said RF output signal, two third and two fourth λ/4 blocking means are coupled to said second RF signal output matching line and configured for blocking against the first and third wavelength of said wavelengths of said RF output signal, and two fifth and two sixth λ/4 blocking means are coupled to said third RF signal output matching line and configured for blocking against the first and second wavelength of said wavelengths of said RF output signal.

According to another embodiment, said RF input signal includes a first, second and third wavelength, said plurality of branched single RF signal input matching lines includes a first and a second RF signal input matching line and said plurality of RF signal output matching lines includes a first and a second RF signal output matching line, said first RF signal input matching line and said first RF signal output matching line are both matched to said first and second wavelength of said RF signal and are each coupled to two first λ/4 blocking means configured for blocking against the third wavelength of said RF input signal, said second RF signal input matching line and said second RF signal output matching line are both matched to said third wavelength of said RF signal and are each coupled to two second and two third λ/4 blocking means each configured for blocking against the first and second wavelength of the RF signal.

According to a second important aspect, the invention provides a method of amplification of an RF input signal having a plurality of different wavelengths, wherein said method comprises the steps of distributing said RF input signal by branching a common RF signal input line which receives said RF input signal into a plurality of single RF signal input matching lines and connecting said single RF signal input matching lines in common to an input terminal of an RF power amplifier component, matching separately each single RF signal input matching line to a respective one of the different wavelengths of the RF input signal and blocking each single RF signal input matching line against the other wavelengths of said RF input signal, connecting a plurality of single RF signal output matching lines in common to an output terminal of said amplifier component, matching separately each single RF signal output line to a respective one of the different wavelengths of the RF input signal and blocking each single RF signal output line against the other of said wavelengths of said RF output signal, and connecting together the plurality of the RF signal output matching lines at their ends opposite to said output terminal of said RF amplifier component to a common RF signal output line for outputting the amplified RF output signal having said plurality of different wavelengths.

Further, in said method, said blocking is performed using λ/4 blocking means being each configured as a capacitive line branching to ground for short-circuiting said at least one wavelength of said RF input and output signal, respectively, against which said respective RF signal input and output matching line is to be blocked.

Said RF broadband amplifier component is implemented as a transistor having a strip line-compatible configuration with terminal lugs as the RF input and output terminals, respectively. Said plurality of branched single RF signal input matching lines and said plurality of single RF signal output matching lines are each configured as strip lines on a supporting substrate, and in case a width of said plurality of RF signal input matching lines in a lateral direction of said supporting substrate is equal to or smaller than a lateral width of said RF input terminal lug of said transistor, the plurality of RF signal input matching lines are arranged side by side in the lateral direction on a common layer of the supporting substrate and connected side by side to said input terminal lug. In case a width of said RF signal input matching lines in a lateral direction of said supporting substrate is greater than a lateral width of said RF input terminal lug of said transistor, the plural RF signal input matching lines are stacked in the vertical direction in different layers of the supporting substrate and vertically connected to said input terminal lug. In case a width of said plurality of RF signal output matching lines in a lateral direction of said supporting substrate is equal to or smaller than a lateral width of said RF output terminal lug of said transistor, the plural signal output matching lines are arranged side by side in the lateral direction on a common layer of the supporting substrate and connected side by side to said output terminal lug, and, in case a width of said plurality of RF signal output matching lines in a lateral direction of said supporting substrate is greater than a lateral width of said RF output terminal lug of said transistor, the plural RF signal output matching lines are stacked in the vertical direction in different layers of the supporting substrate and are vertically connected to said output terminal lug.

Further, in the present invention, said RF input signal may have a first and a different second wavelength, wherein the method further comprises:
branching said common RF signal input line into in to a first and a second RF signal input matching line, and said plurality of RF signal output matching lines includes a first and a second RF signal output matching line, and separately matching said first and second RF signal input and output matching lines to said first and second wavelength of said RF input and output signal,
respectively; blocking said first RF signal input matching line against the second wavelength of said RF input signal; blocking said second RF signal input matching against the first wavelength of said RF input signal; blocking said first RF signal output matching line against the second wavelength of said RF output signal, and blocking said second RF signal output matching line against the first wavelength of said RF output signal.

Alternatively, in the present invention said RF input signal has a first, second and third different wavelength, wherein the method further comprises: branching said common RF signal input line into a first, second and third RF signal input matching line, and said plurality of RF signal output lines into a first, second and third RF signal output matching line; blocking said first RF signal input matching line against the second and third wavelength of said wavelengths of said RF input signal; blocking said second RF signal input matching line against the first and third wavelength of said wavelengths of said RF input signal; blocking said third RF signal input matching line against the first and second wavelength of said wavelengths of said RF input signal; blocking said first RF signal output matching line against the second and third wavelength of said wavelengths of said RF output signal; blocking said second RF signal output matching line against the first and third wavelength of said wavelengths of said RF output signal, and blocking said third RF signal output matching line against the first and second wavelength of said wavelengths of said RF output signal.

Further the amplifier arrangement according to the invention may be embodied in a base station for a cellular communication network.

Still further, the present amplifier arrangement may be embodied in a communication network of a cellular communication system.

### Brief Description of the Drawings

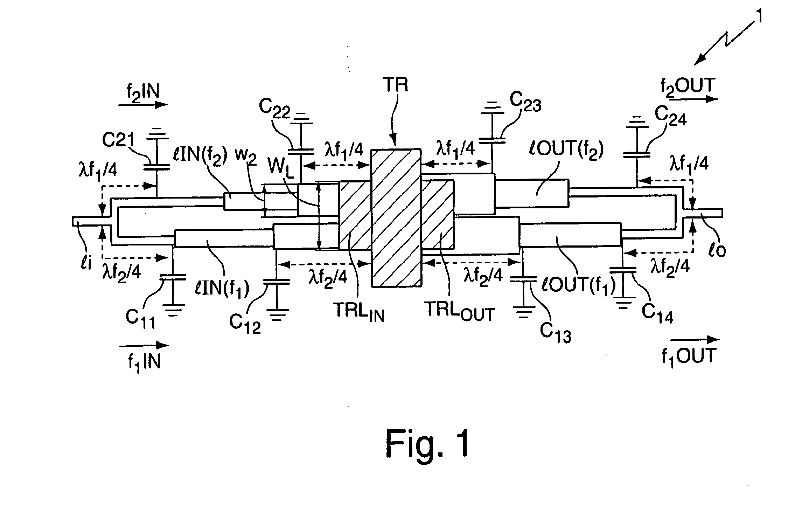

Different embodiments of the amplifier arrangement according to the present invention will be described in detail with reference to the following figures, wherein
- Fig. 1: schematically shows a layout representation of a first embodiment of the present amplifier arrangement configured for amplifying an RF signal having two different wavelengths, wherein two RF signal input matching lines and two RF signal output matching lines are arranged side-by-side on the same plane or layer of a supporting substrate since these RF signal input and output lines fit below the transistor input and output lugs;

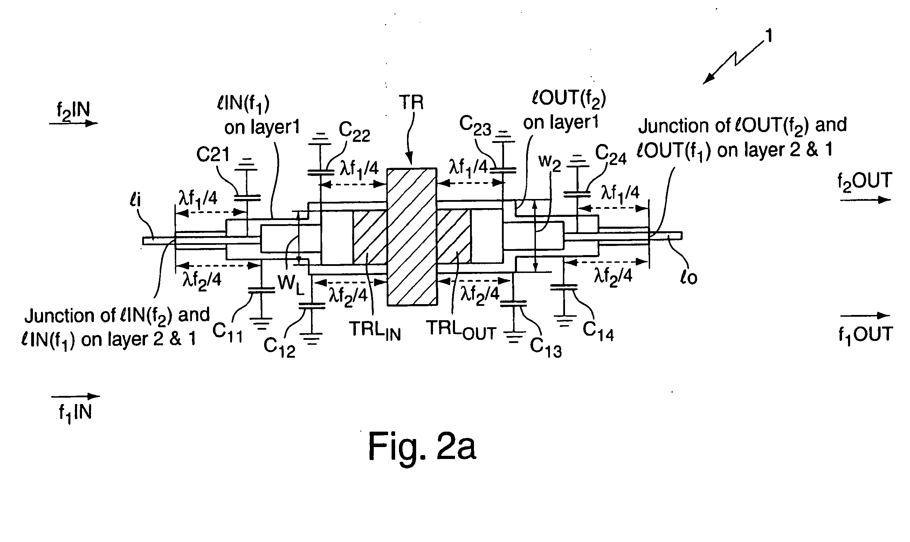

- Fig. 2a: schematically depicts a layout representation of a second embodiment of the present amplifier arrangement configured for amplifying an RF signal having two different wavelengths, wherein the two RF signal input matching lines and the two RF signal output matching lines are respectively stacked one upon another and arranged on different planes or layers of the supporting substrate.

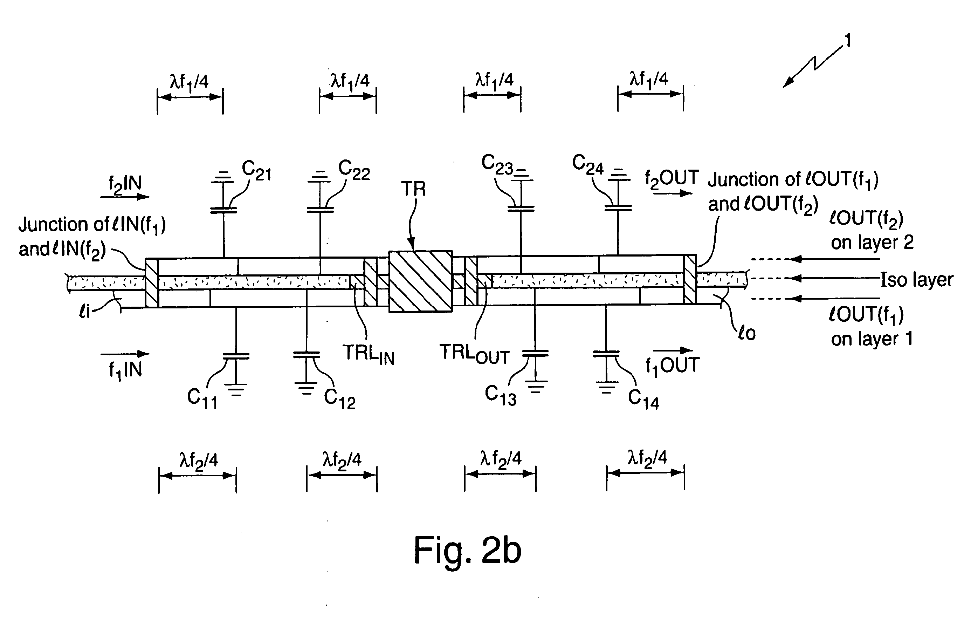

- Fig. 2b: schematically shows a side view of the second preferred embodiment shown in Fig. 2a.

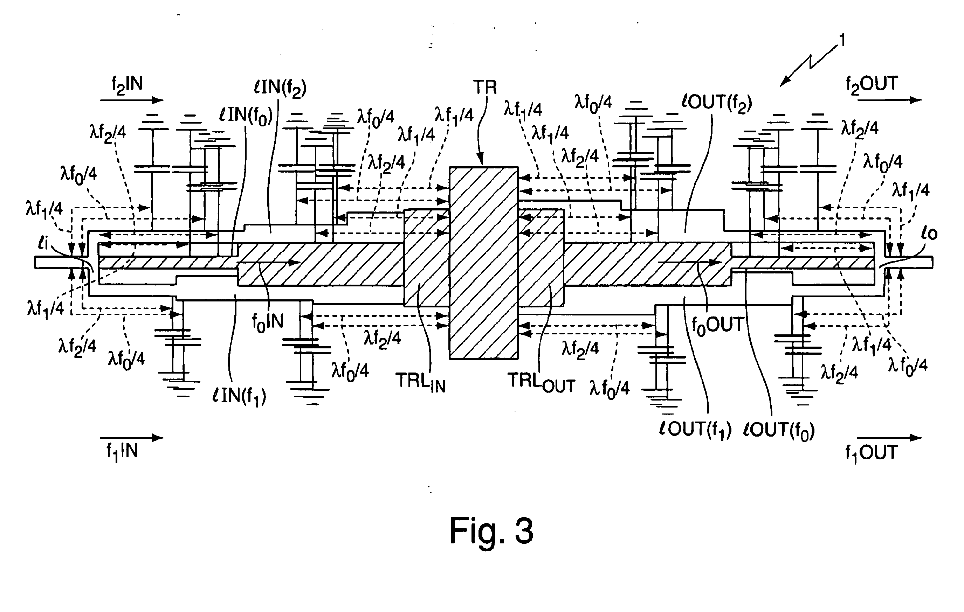

- Fig. 3: schematically shows a layout representation of a third embodiment of the present amplifier arrangement configured for amplifying an RF signal having three different wavelengths, wherein a first RF signal input matching line and a first RF signal output matching line are arranged on a first plane or layer of the supporting substrate and second and third RF signal input matching lines and second and third RF signal output matching lines are respectively arranged side by side on a different second common plane or layer of the supporting substrate.

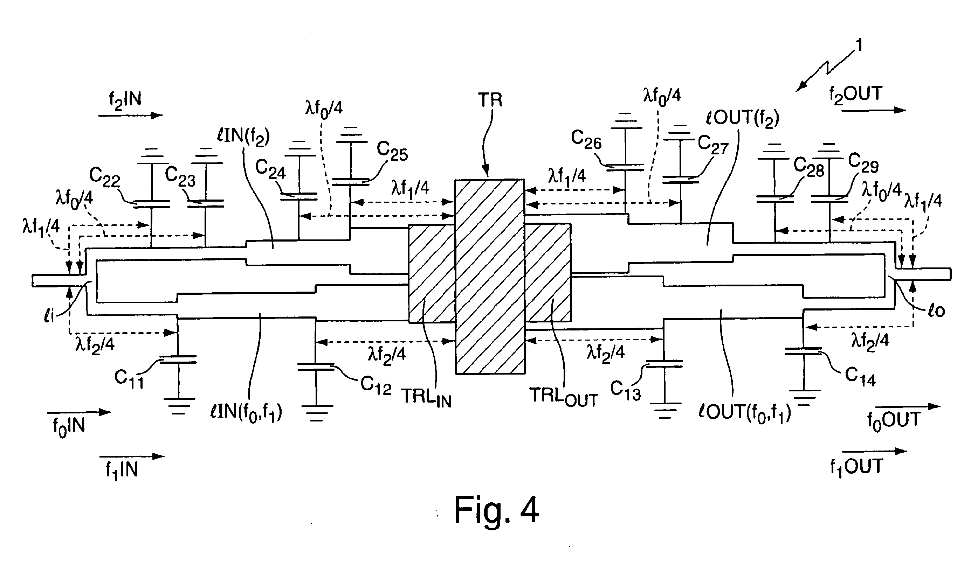

- Fig.4: schematically shows a layout representation of a fourth embodiment of the present amplifier arrangement configured for amplifying an RF signal having three different wavelengths, wherein a first RF signal input matching line and a first RF signal output matching line are configured for matching a first and second wavelength and a second RF signal input matching line and a second RF signal output matching line are configured for matching a third wavelength of the RF signal and the first and second RF signal input and output matching lines are all arranged side by side on the same plane or layer of the supporting substrate, and

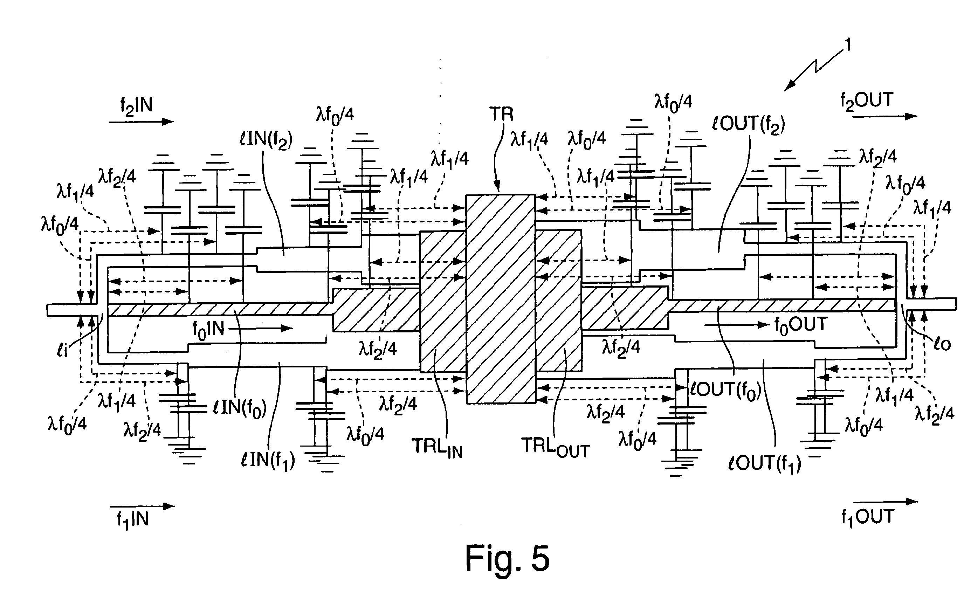

- Fig. 5: schematically shows a layout representation of a fifth embodiment of the present amplifier arrangement configured for amplifying an RF signal having three different wavelengths, wherein a first RF signal input matching line and a first RF signal output matching line are configured for matching a first wavelength of the RF signal, a second RF signal input matching line and a second RF signal output matching line are configured for matching a second wavelength of the RF signal and a third RF signal input matching line and a third RF signal output matching line are configured for matching a third wavelength of the RF signal and all first to third RF signal input and output matching lines are arranged side by side on the same plane or layer of the supporting substrate.

The first embodiment shown in Fig. 1 is configured for the case that the RF signal has two different wavelengths λ_{f1} and λ_{f2} corresponding to two different frequencies f1IN, f1OUT and f2IN, f20UT, respectively. As can be seen from the layout representation in Fig. 1, a common RF signal input line ℓᵢ branches into a first RF signal input matching line ℓIN (f1) and a separate second RF signal input matching line ℓIN (f2) both implemented as strip lines and arranged side-by-side on the same layer of a common supporting substrate (not shown in Fig.1). The first and the second RF signal input matching lines ℓIN(f1) and ℓIN(f2) are connected side-by-side to an input terminal lug TRL_{IN} (corresponding to a transistor flange) of an RF broadband power amplifier transistor TR implemented as a strip line-compatible component. The first and second RF signal input matching lines, ℓIN(f1) and ℓIN (f2) both have a stepped configuration to form a respective RF signal input matching network for impedance matching of said first and second RF signal input matching line ℓIN(f1) and ℓIN (f2) to said first and second frequencies f1IN and f21N, respectively. Further, said first and second RF signal input matching lines ℓIN(f1) and ℓIN (f2) are respectively coupled to a number of λf2/4 and λf1/4 blocking means, two of which are indicated for each of the first and second RF signal input matching lines ℓIN(f1) and ℓIN(f2) by respective capacitors C11, C12 and C21, C22 to guarantee the reverse isolation at the input sides of the first and second RF signal input matching lines ℓIN(f1) and ℓIN(f2) and the opposite sides where the first and second RF signal input matching lines ℓIN(f1) and ℓIN(f2) are connected to the input terminal lug TRL_{IN}. These quarter line protections are short-circuiting at the first RF signal input matching line ℓIN(f1) an input signal having the second wavelength λ_{f2} and at the second RF signal input matching line ℓIN (f2) an input signal having the first wavelength λ_{f1}.

As further depicted in Fig. 1, the first and second RF signal input matching lines ℓIN(f1) and ℓIN(f2) have at their ends where these lines are connected to the input terminal lug TRL_{IN} of the power transistor TR a width in lateral direction of the supporting substrate (only the width of the second RF signal input strip line ℓIN (f2) is designated by the reference sign w2) which is narrow as compared with the width W_{L} of the input terminal lug TRL_{IN} of the power transistor TR.

Further a first and a second RF signal output matching line ℓOUT(f1) and ℓOUT (f2) are respectively arranged side-by-side on the same level of the supporting substrate (not shown) and connected side-by-side to an output terminal lug TRL_{OUT} of the power transistor TR since at the output side of the amplifier arrangement the widths of the first and second RF signal output matching lines ℓOUT(f1) and ℓOUT(f2) are narrow as compared with the width of the RF output terminal lug TRL_{OUT} of the power transistor TR. Like the first and second RF signal input matching lines ℓIN(f1) and ℓIN(f2) the first and second RF signal output matching lines ℓOUT(f1) and ℓOUT(f2) are configured as strip lines having a stepped configuration to form a respective RF signal output matching network for impedance matching of said first and second RF signal output matching lines ℓOUT(f1) and ℓOUT(f2) to said first and second frequency f1OUT and f20UT, respectively. Further, each of said first and second RF signal output matching lines ℓOUT(f1) and ℓOUT(f2) is respectively coupled to a number of λf2/4 and λf1/4 blocking means, two of which are indicated for each of the first and second RF signal output matching lines ℓOUTf(1) and ℓOUT(f2) by capacitors C13, C14 and C23, C24 to guarantee the reverse isolation at the output sides where the first and second RF signal output matching lines ℓOUT(f1) and ℓOUT(f2) are joined together to a common signal output line ℓₒ and at their opposite sides where the first and second RF signal output matching lines ℓOUT(f1) and ℓOUT(f2) are connected to the output terminal lug TRL_{OUT}. These quarter line protections are short circuiting at the first RF signal output matching line ℓOUT(f1) an output signal having the second wavelength λ_{f2} and at the second RF signal output matching line ℓOUT(f2) an output signal having the first wavelength λ_{f1}.

At their ends opposite to the RF power transistor TR the first and second RF signal output matching lines ℓOUT(f1) and ℓOUT(f2) are joined together to form the common RF signal output line ℓₒ for outputting the amplified RF output signal.

The second embodiment of the present amplifier arrangement depicted in Figs 2a and 2b is like the first embodiment configured for the case that the RF input signal has two different wavelengths λ_{f1} and λ_{f2} corresponding to two different frequencies f1IN, f1OUT and f2IN, f20UT, respectively. Besides the arrangement of the first and second RF signal input matching lines ℓIN(f1) and ℓIN(f2) as strip lines in a vertically stacked manner on different plane or layers of a supporting substrate (not shown) and also the physical arrangement of the first and second RF signal output matching lines ℓOUT(f1) and ℓOUT(f2) as strip lines in a vertically stacked manner on different planes or layers of the supporting substrate, the second embodiment is similar to the first embodiment described above with reference to Fig. 1.

As can be clearly seen in Fig. 2a, the combined widths of the first and the second RF signal input matching lines ℓIN(f1) and ℓIN(f2) in the lateral direction of the supporting substrate is wider than the width of the RF input terminal lug TRL_{IN} of the RF power transistor TR indicated by the reference sign W_{L}. Therefore the first and the second RF signal input matching lines ℓIN(f1) and ℓIN(f2) cannot be arranged side-by-side and in this way coupled to the RF input terminal lug TRL_{IN} of the RF power transistor TR as it is done in the first embodiment depicted in Fig. 1.

Likewise, Fig. 2a depicts that the combined widths of the first and second RF signal output matching lines ℓOUT(f1) and ℓOUT(f2), (the latter width being designated by the reference sign w2) are wider than the width of the RF terminal lug TRL_{OUT} of the RF power transistor TR, and therefore the first and second RF signal output matching lines ℓOUT(f1) and ℓOUT(f2) cannot be arranged and coupled to the RF output terminal lug TRL_{OUT} of the power transistor TR side-by-side as it is done in the first embodiment according to Fig. 1.

Fig. 2b shows a schematic side view of the second embodiment depicted in Fig. 2a. Fig. 2b clearly illustrates the vertically stacked arrangement of the first and second RF signal input matching lines ℓIn(f1) and ℓIN(f2) on the different layers 1 and 2 of the supporting substrate (not shown) and their mutual connection at their input ends to the common RF signal input line ℓᵢ in the vertical direction as well as their vertical connection to the RF input terminal lug TRL_{IN} of the RF power transistor TR. Further, Fig 2b clearly depicts the vertically stacked arrangement of the first and second RF signal output matching lines ℓOUT(f1) and ℓOUT(f2) on different layers 1 and 2 of the supporting substrate (not shown) as well as their vertical mutual connection at their output ends to the common RF signal output line ℓₒ and their vertical connection to the RF output terminal lug TRL_{OUT} of the RF power transistor TR. Further Fig. 2b shows an isolation layer Iso which may be provided between the stacked first and second RF signal input matching lines ℓIN(f1) and ℓIN(f2) and between the first and second RF signal output matching lines ℓOUT(f1) and ℓOUT(f2).

A third embodiment of the present amplifier arrangement schematically shown as a layout representation in Fig.3 is configured for amplifying an RF signal having three different wavelengths, wherein a first RF signal input matching strip line and a first RF signal output matching strip line are arranged on a first plane or layer of the supporting substrate (not shown), and second and third RF signal input matching strip lines and second and third RF signal output matching strip lines are respectively arranged side by side on a common second plane or layer of the supporting substrate.

In the third embodiment, the RF signal input and output matching strip lines are routed on two different layers of the supporting substrate. The first RF signal input matching strip line ℓIN(f0) and the first RF signal output matching strip line ℓOUT(f0) for matching the first wavelength of the RF signal are provided e.g. on a top side of the supporting substrate (not shown), e.g. a line card, and the second and third RF signal input matching strip lines ℓIN(f1) and ℓIN(f2) and the second and third RF signal output matching strip lines ℓOUT(f1) and ℓOUT(f2) for matching the second and third wavelength of the RF signal are respectively arranged side-by-side e.g. on a bottom side of the supporting substrate, e.g. the line card (not shown).

The first RF signal input matching strip line ℓIN(f0) and the first RF signal output matching strip line ℓOUT(f0) are each blocked for the second and third frequency f1 and f2 by respective λ_{f1}/4 and λ_{f2}/4 quarter-line protections, respectively indicated by capacitors at the common input line branching point ℓᵢ, at the connection of the first RF signal input matching strip line ℓIN(f0) to the input terminal lug TRL_{IN}, at the connection of the first RF signal output matching strip line ℓOUT (f0) to the output terminal lug TRL_{OUT} and at the output line joining point ℓₒ thereof.

Similarly, the second RF signal input matching strip line ℓIN(f1) and the second RF signal output matching strip line ℓOUT(f1) are each blocked for the first and third frequency f0 and f2 by respective _{λf0}/4 and λ_{f2}/4 quarter-line protections, respectively indicated by capacitors at the input line branching point ℓᵢ, the connection of the second RF signal input matching strip line ℓIN(f1) to the input terminal lug TRL_{IN}, at the connection of the second RF signal output matching strip line ℓOUT (f1) to the output terminal lug TRL_{OUT} and at the output line joining point ℓₒ thereof.

Further, the RF signal input and output paths respectively provided for the third frequency f2 and represented by the third RF signal input matching strip line ℓIN(f2) and the third RF signal output matching strip line ℓOUT(f2) are blocked for the first and second frequencies f0 and f1 by means of respective λ_{fo}/4 and λ_{f1}/4 quarter-line protections as indicated by respective capacitors at the input branching point ℓᵢ, the connections of the third RF signal input matching strip line ℓIN(f2) and the third RF signal output matching strip line ℓOUT(f2) to the input and output terminal lugs TRL_{IN}, TRL_{OUT}, respectively and at the output joining point, ℓₒ.

In a fourth embodiment of the invention schematically depicted in Fig. 4 two adjacent frequencies f0IN and f1IN of the RF signal are transmitted and impedance-matched by a common first RF signal matching strip line ℓIN(f0,f1) and a common first RF signal output matching strip line ℓOUT(f0,f1), while the third frequency f2IN of the three different frequencies of the RF signal is transmitted and matched by a second RF signal input matching strip line ℓIN(f2) and a second RF signal output matching strip line ℓOUT(f2). Thus, the lower RF signal input and output paths in Fig. 4 represented by the first RF signal input matching strip line ℓIN(f0,f1) and the first RF signal output matching strip line ℓOUT(f0,f1) are each blocked for the third frequency f2 by the λ_{f2}/4 quarter-line protection, respectively indicated by capacitors C₁₁ to C₁₄ at the input line branching point ℓᵢ, the connection of the first RF signal input matching strip line ℓIN(f0,f1) to the input terminal lug TRL_{IN}, at the connection of the first RF signal output matching strip line ℓOUT(f0,f1) to the output terminal lug TRL_{OUT} and at the output line joining point ℓₒ thereof. Further; the upper RF signal input and output paths provided for the third frequency f2 are blocked for the two frequencies f0 and f1 by means of λ_{f1}/4 and λ_{f0}/4 quarter-line protections as indicated by respective capacitors C₂₂ to C₂₉ at the input line branching point ℓᵢ, the connections of the second RF signal input matching strip line ℓIN(f2) and the second RF signal output matching strip line ℓOUT(f2) to the input and output terminal lugs TRL_{IN}, TRL_{OUT}, respectively and at the output line joining point ℓᵢ of the first and second RF signal output matching strip lines ℓOUT(f1) and ℓOUT(f2).

The layout representation of the fifth embodiment of the present amplifier arrangement schematically shown in Fig. 5 is configured like the third and fourth embodiment schematically depicted in Figs. 3 and 4 for amplifying an RF signal having three different wavelengths λ_{f0}, λ_{f1}, λ_{f2}, wherein a first RF signal input matching strip line ℓIN(f0) and a first RF signal output matching strip line ℓOUT(f0) are configured for impedance matching the first wavelength λ_{f0} of the RF signal, a second RF signal input matching strip line ℓIN(f1) and a second RF signal output matching strip line ℓOUT(f1) are configured for impedance matching the second wavelength λ_{f1} of the RF signal and a third RF signal input matching strip line ℓIN(f2) and a third RF signal output matching strip line ℓOUT(f2) are configured for impedance matching a third wavelength of the RF signal and all these first to third RF signal input and output matching strip lines are arranged side by side on the same plane or layer of the supporting substrate (not shown).

In contrast to the third embodiment shown in Fig.3, in the embodiment of the present amplifier arrangement according to Fig. 5 the three distinct RF signal input matching strip lines ℓIN(f0), ℓIN(f1) and ℓIN(f2) can be arranged side-by-side and fit below the transistor input terminal lug TRL_{IN}. Further, also the first to third RF signal output matching strip lines ℓOUT(f0), ℓOUT(f1) and ℓOUT(f2) are arranged side-by-side and fit below the transistor output terminal lug. As a consequence, the RF signal input strip lines and the RF signal output strip lines can be arranged on the same plane or layer of the supporting substrate.

Since in the fifth embodiment according to Fig. 5 each of the three distinct RF signal input matching strip lines and RF signal output matching strip lines transmits precisely one frequency, that is one of the three different wavelengths λ_{f0}, λ_{f1}, λ_{f2} of the RF signal, this means in the reverse that each of the RF signal input matching strip lines and RF signal output matching strip lines has to block the remaining two frequencies which are not travelling through said distinct RF signal input matching strip line and RF signal output matching strip line.

Thus, like in the third embodiment shown in Fig. 3, the first RF signal input matching strip line ℓIN(f0) and the first RF signal output matching strip line ℓOUT(f0) are each blocked for the second and third frequency f1 and f2 by respective λ_{f1}/4 and λ_{f2}/4 quarter-line protections, respectively indicated by capacitors at the input line branching point ℓᵢ, at the connection of the first RF signal input matching strip line ℓIN(f0) to the input terminal lug TRL_{IN}, at the connection of the first RF signal output matching strip line ℓOUT(f0) to the output terminal lug TRL_{OUT} and at the output joining point ℓₒ thereof.

Similarly, the second RF signal input matching strip line ℓIN(f1) and the second RF signal output matching strip line ℓlOUT(f1) are each blocked for the first and third frequency f0 and f2 by respective λ_{f0}/4 and λ_{f2}/4 quarter-line protections, respectively indicated by capacitors at the input line branching point ℓᵢ, the connection of the second RF signal input matching strip line ℓIN(f1) to the input terminal lug TRL_{IN}, at the connection of the second RF signal output matching strip line ℓOUT(f1) to the output terminal lug TRL_{OUT} and at the output line joining point ℓₒ thereof.

Further, the RF signal input and output paths respectively provided for the third frequency f2 and represented by the third RF signal input matching strip line ℓIN(f2) and the third RF signal output matching strip line ℓOUT(f2) are blocked for the first and second frequencies f0 and f1 by means of respective λ_{fo}/4 and λ_{f1}/4 quarter-line protections as indicated by respective capacitors at the input branching point ℓᵢ, the connections of the third RF signal input matching strip line ℓIN(f2) and the third RF signal output matching strip line ℓOUT(f2) to the input and output terminal lugs TRL_{IN}, TRL_{OUT}, respectively and at the output joining point ℓₒ.

For the first to fifth embodiments, the RF power transistor TR can be implemented by means of a broadband power transistor typically based on III-V GaN Technology.

From the above description of the first to fifth embodiments, the skilled person can easily grasp that these embodiments also encompass a method of amplification of an RF input signal having a plurality of different wavelengths, wherein said method comprises the steps of distributing said RF input signal by branching a common RF signal input line which receives said RF input signal into a plurality of single RF signal input matching lines and connecting said single RF signal input matching lines in common to an input terminal of an RF power amplifier component, matching separately each single RF signal input matching line to a respective one of the different wavelengths of the RF input signal and blocking each single RF signal input matching line against the other wavelengths of said RF input signal, connecting a plurality of single RF signal output matching lines in common to an output terminal of said amplifier component, matching separately each single RF signal output line to a respective one of the different wavelengths of the RF input signal and blocking each single RF signal output line against the other of said wavelengths of said RF output signal, and connecting together the plurality of the RF signal output matching lines at their ends opposite to said output terminal of said RF amplifier component to a common RF signal output line for outputting the amplified RF output signal having said plurality of different wavelengths.

The architecture of the first to fifth embodiments depicted in Figs. 1 to 5 is scalable, i.e., the number of different RF signal input and output matching lines can be defined by the number of potentially addressed frequency blocks. That is, the number of two or three different wavelengths λ_{f1} and λ_{f2} is only an example, and the present amplifier arrangement can be scaled to process a greater number of different wavelengths, for example four or even more different wavelengths.

Further the amplifier arrangement of the present invention described above can be comprised in a base station for a cellular communication network.

Even further the amplifier arrangement of the present invention as described above can be employed in a communication network of a cellular communication system.

A power amplification for fragmented transceiver systems employing the present amplifier arrangement has the following advantageous features:
- synchronous operation of different standards in different frequency bands;
- bandwidths of up to 1 GHz may be covered;
- flexible frequency and load management for different standards;
- flexible configuration of the selectable frequency bands by device options in the matching network.

## Claims

1. An amplifier arrangement (1) adapted for amplification of an RF input signal having a plurality of different wavelengths (λf₀, λf₁, λf₂) and being input through different input lines either serially or in parallel, said amplifier arrangement (1) comprising:
- An RF broadband amplifier component (TR) having an input terminal (TRL_{IN}) and an output terminal (TRL_{OUT}),
- a common RF signal input line (ℓᵢ) being arranged for receiving said RF input signal and branching into a plurality of single RF signal input matching lines connected in common to the input terminal (TRL_{IN}) of said RF amplifier component (TR), and each single RF signal input matching line (ℓIN(f₀), ℓIN(f₁), ℓIN(f₂₎) forming an RF signal input matching network configured for matching said single RF signal input matching line to at least one of said wavelengths (λf₀, λf₁, λf₂) travelling through said single RF signal input matching line (ℓIN(f₀), ℓIN(f₁), ℓIN(f₂)), wherein each single RF signal input matching line (ℓIN(f₀), ℓIN(f₁), ℓIN(f₂)) at its branching point and at its connection to the input terminal (TRL_{IN}) of said RF amplifier is respectively coupled to λ/4 blocking means (C₁₁, C₁₂, C₂₁ to C₂₅) for blocking against one or more wavelengths (λf₀, λf₁, λf₂) of said RF input signal to which said respective RF signal input matching line ℓIN(fo), ℓIN(f₁), ℓIN(f₂) is not matched; and
- a plurality of RF signal output matching lines (ℓOUT(f₀), ℓOUT(f₁), ℓOUT(f₂)) being connected in common to the output terminal (TRL_{OUT}) of said amplifier component (TR), and each single RF signal output matching line (ℓOUT(f₀), ℓOUT(f₁), ℓOUT(f₂)) forming an RF signal output matching network configured for matching said single RF signal output matching line (ℓOUT(f₀), ℓOUT(f₁), ℓOUT(f₂)) to at least one of said wavelengths (λf₀, λf₁, λf₂) travelling through said single RF signal output matching line (ℓOUT(f₀), ℓOUT(f₁), ℓOUT(f₂)), and the plurality of the RF signal output matching lines (ℓOUT(f₀), ℓOUT(f₁), ℓOUT(f₂)) being connected together at their ends opposite to said output terminal (TRL_{OUT}) of said RF amplifier component (TR) to become a common RF signal output line (ℓ₀) for outputting the amplified RF output signal having said plurality of different wavelengths (λf₀, λf₁, λf₂), wherein each single RF signal output matching line (ℓOUT(f₀), ℓOUT(f₁), ℓOUT(f₂)) at its connection point to the output terminal (TRL_{OUT}) of said RF amplifier component (TR) and at its connection point to the other RF signal output matching lines (ℓOUT(f₀), ℓOUT(f₁), ℓOUT(f₂)) is respectively coupled to λ/4 blocking means (C₁₃, C₁₄, C₂₃, C₂₄, C₂₆ to C₂₉) for blocking against one or more wavelengths (λf₀, λf₁, λf₂) of said RF output signal to which said respective RF signal output matching line (ℓOUT(f₀), ℓOUT(f₁), ℓOUT(f₂)) is not matched, said plurality of branched single RF signal input matching lines (ℓIN(f₀), ℓIN(f₁), ℓIN(f₂)) and said plurality of single RF signal output matching lines (ℓOUT(f₀), ℓOUT(f₁), ℓOUT(f₂)) are each configured as strip lines on a supporting substrate,
**characterized in that**
said λ/4 blocking means are each configured as a capacitive line (C₁₁ to C₁₄; C₂₁ to C₂₉) branching to ground for short-circuiting said at least one wavelength (λf₀, λf₁, λf₂) of said RF input and output signal, respectively, against which said respective RF signal Input and output matching line (ℓIN(f₀), ℓIN(f₁), ℓIN(f₂)), (ℓOUT(f₀), ℓOUT(f₁), ℓOUT(f₂)) is to be blocked, said RF broadband amplifier component (TR) is implemented as a transistor having a strip line-compatible configuration with terminal lugs as the RF input and output terminals (TRL_{IN}, TRL_{OUT}), respectively;
wherein
in case a width of said plurality of RF signal input matching lines (ℓIN(f₀), ℓIN(f₁), ℓIN(f₂)) in a lateral direction of said supporting substrate is equal to or smaller than a lateral width of said RF input terminal lug (TRL_{IN}) of said transistor (TR), the plurality of RF signal input matching lines (ℓIN(f₀), ℓIN(f₁),
ℓIN(f₂)) are arranged side by side in the lateral direction on a common layer of the supporting substrate and are connected side by side to said input terminal lug (TRL_{IN}),
In case a width of said RF signal input matching lines (ℓIN(f₀), ℓIN(f₁), ℓIN(f₂)) in a lateral direction of said supporting substrate is greater than a lateral width of said RF input terminal lug (TRL_{IN}) of said transistor (TR), the plural RF signal input matching lines (ℓIN(f₀), ℓIN(f₁), ℓIN(f₂)) are stacked in the vertical direction in different layers of the supporting substrate and are vertically connected to said input terminal lug (TRL_{IN});
in case a width of said plurality of RF signal output matching lines (ℓOUT(f₀), ℓOUT(f₁), ℓOUT(f₂)) in a lateral direction of said supporting substrate is equal to or smaller than a lateral width of said RF output terminal lug (TRL_{OUT}) of said transistor (TR), the plural signal output matching lines (ℓOUT(f₀), ℓOUT(f₁), ℓOUT(f₂)) are arranged side by side in the lateral direction on a common layer of the supporting substrate and are connected side by side to said output terminal lug (TRL_{OUT}), and
in case a width of said plurality of RF signal output matching lines (ℓOUT(f₀), ℓOUT(f₁), ℓOUT(f₂)) in a lateral direction of said supporting substrate is
greater than a lateral width of said RF output terminal lug (TRL_{OUT}) of said transistor (TR), the plural RF signal output matching lines (ℓOUT(f₀), ℓOUT(f₁), ℓOUT(f₂)) are stacked in the vertical direction in different layers of the supporting substrate and are vertically connected to said output terminal lug (TRL_{OUT}).

2. The amplifier arrangement as claimed in claim 1, wherein
- said RF input signal has a first and second wavelength (λf₁, λf₂);
- a first and a second RF signal input matching line (ℓIN(f₁), ℓIN(f₂)) and a first and a second RF signal output matching line (ℓOUT(f₁), ℓOUT(f₂)) are respectively provided, each single RF signal input matching line (ℓIN(f₁), ℓIN(f₂)) being respectively coupled to two associated λ/4 blocking means (C₁₁, C₁₂, C₂₁, C₂₂) each configured for blocking the respective RF signal input line (ℓIN(f₁), ℓIN(f₂)) against one of said first and second wavelengths (λf₁, λf₂) of the RF input signal to which the respective RF signal input matching line (ℓIN(f₁), ℓIN(f₂)) is not matched, and each single RF signal output matching line (ℓOUT(f₁), ℓOUT(f₂)) being respectively coupled to two associated λ/4 blocking means (C₁₃, C₁₄, C₂₃, C₂₄) each configured for blocking the respective RF signal output line against one of said first and second wavelengths (λf₁, λf₂) of the RF output signal to which said respective RF signal output matching line (ℓOUT(f₁), ℓOUT(f₂)) is not matched.

3. The amplifier arrangement as claimed in claim 1, wherein
- said RF input signal has three different wavelengths (λf₀, λf₁, λf₂);
- said plurality of branched single RF signal input matching lines includes a first, second and third RF signal input matching line (ℓIN(f₀), ℓIN(f₁), ℓIN(f₂)) and said plurality of RF signal output matching lines (ℓOUT(f₀), ℓOUT(f₁), ℓOUT(f₂)) includes a first, second and third RF signal output matching line (ℓOUT(f₀), ℓOUT(f₁), ℓOUT(f₂));
- two first and two second λ/4 blocking means are coupled to said first RF signal input matching line (ℓIN(f₀)) and configured for blocking against the second and third wavelength (λf₁, λf₂) of said wavelengths (λf₀, λf₁, λf₂) of said RF input signal;
- two third and two fourth λ/4 blocking means are coupled to said second RF signal input matching line (ℓIN(f₁)) and configured for blocking against the first and third wavelength (λf₀, λf₂) of said wavelengths (λf₀, λf₁, λf₂) of said RF input signal;
- two fifth and two sixth λ/4 blocking means are coupled to said third RF signal input line (ℓIN(f₂)) and configured for blocking against the first and second wavelength (λf₀, λf₁) of said wavelengths (λf₀, λf₁, λf₂) of said RF input signal;
- two first and two second λ/4 blocking means are coupled to said first RF signal output matching line (ℓOUT(f₀)) and configured for blocking against the second and third wavelength (λf₁, λf₂) of said wavelengths (λf₀, λf₁, λf₂) of said RF output signal;
- two third and two fourth λ/4 blocking means are coupled to said second RF signal output matching line (ℓOUT(f₁)) and configured for blocking against the first and third wavelength (λf₀, λf₂) of said wavelengths (λf₀, λf₁, λf₂) of said RF output signal, and
- two fifth and two sixth λ/4 blocking means are coupled to said third RF signal output matching line (ℓOUT(f₂)) and configured for blocking against the first and second wavelength (λf₀, λf₁) of said wavelengths (λf₀, λf₁, λf₂) of said RF output signal.

4. The amplifier arrangement as claimed in claim 1, wherein
- said RF input signal includes a first, second and third wavelength (λf₀, λf₁, λf₂);
- said plurality of branched single RF signal input matching lines includes a first and a second RF signal input matching line (ℓIN(f₀, f₁), ℓIN(f₂)) and said plurality of RF signal output matching lines includes a first and a second RF signal output matching line (ℓOUT(f₀,f₁), ℓOUT(f₂));
- said first RF signal input matching line (ℓIN(f₀,f₁)) and said first RF signal output matching line (ℓOUT(f₀,f₁)) are both matched to said first and second wavelength (λf₀, λf₁) of said RF signal and are each coupled to two first λ/4 blocking means (C₁₁ to C₁₄) configured for blocking against the third wavelength (λf₂) of said RF input signal;
- said second RF signal input matching line (ℓIN(f₂)) and said second RF signal output matching line (ℓOUT(f₂)) are both matched to said third wavelength (λf₂) of said RF signal and are each coupled to two second and two third λ/4 blocking means (C₂₂ to C₂₉) each configured for blocking against the first and second wavelength (λf₀, λf₁) of the RF signal.

5. A method of amplification of an RF input signal having a plurality of different wavelengths (λf₀, λf₁, λf₂), said method comprising the steps of:
- Distributing said RF input signal by branching a common RF signal input line (ℓᵢ) which receives said RF input signal into a plurality of single RF signal input matching lines (ℓIN(f₀), ℓIN(f₁), ℓIN(f₂)) and connecting said single RF signal input matching lines (ℓIN(f₀), ℓIN(f₁), ℓIN(f₂)) in common to an input terminal (TRL_{IN}) of an RF power amplifier component (TR), matching separately each single RF signal input matching line ℓIN(f₀), ℓIN(f₁), ℓIN(f₂)) to a respective one of the different wavelengths (λf₀, λf₁, λf₂) of the RF input signal and blocking each single RF signal input matching line (ℓIN(f₀), ℓIN(f₁), ℓIN(f₂)) against the other wavelengths (λf₀, λf₁, λf₂) of said RF input signal;
- connecting a plurality of single RF signal output matching lines (ℓOUT(f₀), ℓOUT(f₁), ℓOUT(f₂)) in common to an output terminal (TRL_{OUT}) of said amplifier component (TR), matching separately each single RF signal output line (ℓOUT(f₀), ℓOUT(f₁), ℓOUT(f₂)) to a respective one of the different wavelengths (λf₀, λf₁, λf₂) of an RF outpout signal and blocking each single RF signal output line (ℓOUT(f₀), ℓOUT(f₁), ℓOUT(f₂)) against the other of said wavelengths (λf₀, λf₁, λf₂) of said RF output signal; and
- connecting together the plurality of the RF signal output matching lines (ℓOUT(f₀), ℓOUT(f₁), ℓOUT(f₂)) at their ends opposite to said output terminal (TRL_{OUT}) of said RF amplifier component (TR) to a common RF signal output line (ℓOUT(f₀), ℓOUT(f₁), ℓOUT(f₂)) for outputting the amplified RF output signal having said plurality of different wavelengths (λf₀, λf₁, λf₂), said plurality of branched single RF signal input matching lines (ℓIN(f₀), ℓIN(f₁), ℓIN(f₂)) and said plurality of single RF signal output matching lines (ℓOUT(f₀), ℓOUT(f₁), ℓOUT(f₂)) are each configured as strip lines on a supporting substrate,
**characterized in that**
said blocking is performed using λ/4 blocking means being each configured as a capacitive line (C₁₁ to C₁₄; C₂₁ to C₂₉) branching to ground for short-circuiting said at least one wavelength (λf₀, λf₁, λf₂) of said RF input and output signal, respectively, against which said respective RF signal input and output matching line (ℓIN(f₀), ℓIN(f₁), ℓIN(f₂)), (ℓOUT(f₀), ℓOUT(f₁), ℓOUT(f₂)) is to be blocked, wherein said RF broadband amplifier component (TR) is implemented as a transistor having a strip line-compatible configuration with terminal lugs as the RF input and output terminals (TRL_{IN}, TRL_{OUT}), respectively; wherein
the method further comprising:
in case a width of said plurality of RF signal input matching lines (ℓIN(f₀), ℓIN(f₁), ℓIN(f₂)) in a lateral direction of said supporting substrate is equal to or
- smaller than a lateral width of said RF input terminal lug (TRL_{IN}) of said transistor (TR), arranging the plurality of RF signal input matching lines (ℓIN(f₀), ℓIN(f₁), ℓIN(f₂)) side by side in the lateral direction on a common layer of the supporting substrate and connecting them side by side to said input terminal lug (TRL_{IN}),
in case a width of said RF signal input matching lines (ℓIN(f₀), ℓIN(f₁), ℓIN(f₂)) in a lateral direction of said supporting substrate is greater than a lateral width of said RF input terminal lug (TRL_{IN}) of said transistor (TR), stacking the plural RF signal input matching lines (ℓIN(f₀), ℓIN(f₁), ℓIN(f₂)) in the vertical direction in different layers of the supporting substrate and vertically connecting them to said input terminal lug (TRL_{IN});
In case a width of said plurality of RF signal output matching lines (ℓOUT(f₀), ℓOUT(f₁), ℓOUT(f₂)) in a lateral direction of said supporting substrate is equal to or smaller than a lateral width of said RF output terminal lug (TRL_{OUT}) of said transistor (TR), arranging the plural signal output matching lines (ℓOUT(f₀), ℓOUT(f₁), ℓOUT(f₂)) side by side in the lateral direction on a common layer of the supporting substrate and connecting them side by side to said output terminal lug (TRL_{OUT}), and
in case a width of said plurality of RF signal output matching lines (ℓOUT(f₀), ℓOUT(f₁), ℓOUT(f₂)) in a lateral direction of said supporting substrate is greater than a lateral width of said RF output terminal lug (TRL_{OUT}) of said transistor (TR), stacking the plural RF signal output matching lines (ℓOUT(f₀), ℓOUT(f₁), ℓOUT(f₂)) in the vertical direction in different layers of the supporting
substrate and vertically connecting them to said output terminal lug (TRL_{OUT}).

6. The method as claimed in claim 5, wherein
said RF input signal has a first and a different second wavelength (λf₁, λf₂), and the method further comprises:
- branching said common RF signal input line (ℓ₁) into in to a first and a second RF signal input matching line (ℓIN(f₁), ℓIN(f₂)), and said plurality of RF signal output matching lines (ℓOUT(f₁), ℓOUT(f₂)) includes a first and a second RF signal output matching line (ℓOUT(f₁), ℓOUT(f₂)), and separately matching said first and second RF signal input and output matching lines (ℓIN(f₁), ℓIN(f₂), ℓOUT(f₁), ℓOUT(f₂)) to said first and second wavelength (λf₁, λf₂) of said RF input and output signal, respectively;
- blocking said first RF signal input matching line (ℓIN(f₁)) against the second wavelength (λf₂) of said RF input signal;
- blocking said second RF signal input matching (ℓIN(f₂)) against the first wavelength (λf₁) of said RF input signal;
- blocking said first RF signal output matching line (ℓOUT(f₁)) against the second wavelength (λf₂) of said RF output signal, and
- blocking said second RF signal output matching line (ℓOUT(f₂)) against the first wavelength (λf₁) of said RF output signal.

7. The method as claimed in claim 5, wherein
- said RF input signal has different first, second and third wavelengths (λf₀, λf₁, λf₂) and the method further comprises:
- branching said common RF signal input line (ℓ₁) into a first, second and third RF signal input matching line (ℓIN(f₀), ℓIN(f₁), ℓIN(f₂)); and said plurality of RF signal output lines includes a first, second and third RF signal output matching line (ℓOUT(f₀), ℓOUT(f₁), ℓOUT(f₂));
- blocking said first RF signal input matching line (ℓIN(f₀)) against the second and third wavelength (λf₁, λf₂) of said wavelengths (λf₀, λf₁, λf₂) of said RF input signal;
- blocking said second RF signal input matching line (ℓIN(f₁)) against the first and third wavelength (λf₀, λf₂) of said wavelengths (λf₀, λf₁, λf₂) of said RF input signal;
- blocking said third RF signal input matching line (ℓIN(f₂)) against the first and second wavelength (λf₀, λf₁, of said wavelengths (λf₀, λf₁, λf₂) of said RF input signal;
- blocking said first RF signal output matching line (ℓOUT(f₀)) against the second and third wavelength (λf₁, λf₂) of said wavelengths (λf₀, λf₁, λf₂) of said RF output signal;
- blocking said second RF signal output matching line (ℓOUT(f₁)) against the first and third wavelength (λf₀, λf₂) of said wavelengths (λf₀, λf₁, λf₂) of said RF output signal, and
- blocking said third RF signal output matching line (ℓOUT(f₂)) against the first and second wavelength (λf₀, λf₁) of said wavelengths (λf₀, λf₁, λf₂) of said RF output signal.

8. A base station for a cellular communication network employing said amplifer arrangement (1) as claimed in claim 1.

9. A communication network of a cellular communication system employing said amplifier arrangement (1) as claimed in claim 1.

10. A computer program product comprising code means for performing the steps according to claim 5.

## Patentansprüche

1. Verstärkeranordnung (1), ausgelegt für die Verstärkung von RF-Eingangssignalen mit einer Mehrzahl von verschiedenen Wellenlängen (λf₀, λf₁, λf₂), welche über verschiedene Eingangsleitungen entweder hintereinander oder parallel eingespeist werden, wobei die besagte Verstärkeranordnung (1) umfasst:
- Eine RF-Breitbandverstärkerkomponente (TR) mit einem Eingangsanschluss (TRL_{IN}) und einem Ausgangsanschluss (TRL_{OUT}),
- eine gemeinsame RF-Signaleingangsleitung (ℓ₁), welche dazu ausgelegt ist, das besagte RF-Eingangssignal zu empfangen und sich in eine Mehrzahl von einzelnen RF-Signaleingangsanpassungsleitungen, die gemeinsam an den Eingangsanschluss (TRL_{IN}) der besagten RF-Verstärkerkomponente (TR) angeschlossen sind, zu verzweigen, und wobei jede einzelne RF-Signaleingangsanpassungsleitung (ℓIN(f₀), ℓIN(f₁), ℓIN(f₂)) ein RF-Signaleingangsanpassungsnetzwerk bildet, welches für das Anpassen der besagten einzelnen RF-Signaleingangsanpassungsleitungen an mindestens eine der besagten Wellenlängen (λf₀, λf₁, λf₂), die durch die besagte einzelne RF-Signaleingangsanpassungsleitung (ℓIN(f₀), ℓIN(f₁), ℓIN(f₂)) laufen, konfiguriert ist, wobei jede einzelne RF-Signaleingangsanpassungsleitung (ℓIN(f₀), ℓIN(f₁), ℓIN(f₂)) an ihrem Verzweigungspunkt und an ihrem Anschluss an den Eingangsanschluss (TRL_{IN}) des besagten RF-Verstärkers jeweils an λ/4-Blockiermittel (C₁₁, C₁₂, C₂₁ bis C₂₅) zum Blockieren gegen eine oder mehrere Wellenlängen (λf₀, λf₁, λf₂) des besagten RF-Eingangssignals, an welche die besagte jeweilige RF-Signaleingangsanpassungsleitung (ℓIN(f₀), ℓIN(f₁), ℓIN(f₂) nicht angepasst ist, gekoppelt ist; und
- eine Mehrzahl von RF-Signalausgangsanpassungsleitungen (ℓOUT(f₀), ℓOUT(f₁), ℓOUT(f₂)), welche gemeinsam an den Ausgangsanschluss (TRL_{OUT}) der besagten Verstärkerkomponente (TR) angeschlossen sind, und wobei jede einzelne RF-Signalausgangsanpassungsleitung (ℓOUT(f₀), ℓOUT(f₁), ℓOUT(f₂)) ein RF-Signalausgangsanpassungsnetzwerk bildet, welches für das Anpassen der besagten einzelnen RF-Signalausgangsanpassungsleitung (ℓOUT(f₀), ℓOUT(f₁), ℓOUT(f₂)) an mindestens eine der besagten Wellenlängen (Af₀, λf₁, λf₂), die durch die besagte einzelne RF-Signalausgangsanpassungsleitung (ℓOUT(f₀), ℓOUT(f₁), ℓOUT(f₂)) laufen, konfiguriert ist, und wobei die Mehrzahl der RF-Signalausgangsanpassungsleitungen (ℓOUT(f₀), ℓOUT(f₁), ℓOUT(f₂)) an deren Enden, welche dem besagten Ausgangsanschluss (TRL_{OUT}) der besagten RF-Verstärkerkomponente (TR) gegenüberliegen, miteinander verbunden sind, um eine gemeinsame RF-Signalausgangsleitung (ℓₒ) für die Ausgabe des verstärkten RF-Ausgangssignals mit der besagten Mehrzahl von verschiedenen Wellenlängen (λf₀, λf₁, λf₂) zu bilden, wobei jede einzelne RF-Signalausgangsanpassungsleitung (ℓOUT(f₀), ℓOUT(f₁), ℓOUT(f₂)) an ihrem Anschlusspunkt an den Ausgangsanschluss (TRL_{OUT}) der besagten RF-Verstärkerkomponente (TR) und an ihrem Anschlusspunkt an die anderen RF-Signalausgangsanpassungsleitungen (ℓOUT(f₀), ℓOUT(f₁), ℓOUT(f₂)) jeweils an λ/4 Blockiermittel (C₁₃, C₁₄, C₂₃, C₂₄, C₂₆ bis C₂₉) zum Blockieren gegen eine oder mehrere Wellenlängen (λf₀, λf₁, λf₂) des besagten RF-Ausgangssignals, an welches die besagte jeweilige RF-Signalausgangsanpassungsleitung (ℓOUT(f₀), ℓOUT(f₁), ℓOUT(f₂)) nicht angepasst ist, gekoppelt ist, wobei die besagte Mehrzahl von verzweigten einzelnen RF-Signaleingangsanpassungsleitungen (ℓIN(f₀), ℓIN(f₁), ℓIN(f₂)) und die besagte Mehrzahl von einzelnen RF-Signalausgangsanpassungsleitungen (ℓIOUT(f₀), ℓOUT(f₁), ℓOUT(f₂)) jeweils als Streifenleitungen auf einem Trägersubstrat konfiguriert sind,
**dadurch gekennzeichnet, dass**
die besagten λ/4-Blockiermittel jeweils als eine kapazitive Leitung (C₁₁ bis C₁₄; C₂₁ bis C₂₉), die für die Erdung verzweigt wird, um die besagte mindestens eine jeweilige Wellenlänge (λf₀, λf₁, λf₂) des besagten RF-Eingangs- und RF-Ausgangssignals, gegen welche die besagte entsprechende RF-Signaleingangs- und -ausgangsanpassungsleitung (ℓIN(f₀), ℓIN(f₁), ℓIN(f₂)), (ℓOUT(f₀), ℓOUT(f₁), ℓOUT(f₂)) blockiert werden soll, kurzzuschließen, konfiguriert sind,
die besagte RF-Breitbandverstärkerkomponente (TR) als ein Transistor mit einer streifenleitungskompatiblen Konfiguration mit jeweiligen Anschlussfahnen als RF-Eingangs- und -Ausgangsanschluss (TRL_{IN}, TRL_{OUT}) eingesetzt wird; wobei wenn eine Breite der besagten Mehrzahl von RF-Signaleingangsanpassungsleitungen (ℓIN(f₀), ℓIN(f₁), ℓIN(f₂)) in einer seitlichen Richtung des besagten Trägersubstrats gleich einer oder kleiner als eine seitliche Breite der besagten RF-Eingangsanschlussfahne (TRL_{IN}) des besagten Transistors (TR) ist, die Mehrzahl der RF-Signaleingangsanpassungsleitungen (ℓIN(f₀), ℓIN(f₁), ℓIN(f₂)) nebeneinander in der seitlichen Richtung auf einer gemeinsamen Schicht des Trägersubstrats angeordnet und nebeneinander an der besagten Eingangsanschlussfahne (TRL_{IN}) angeschlossen werden,
wenn eine Breite der besagten RF-Signaleingangsanpassungsleitungen (ℓIN(f₀), ℓIN(f₁), ℓIN(f₂)) in einer seitlichen Richtung des besagten Trägersubstrats größer als eine seitliche Breite der besagten RF-Eingangsanschlussfahne (TRL_{IN}) des besagten Transistors (TR) ist, die mehrfachen RF-Signaleingangsanpassungsleitungen (ℓIN(f₀), ℓIN(f₁), ℓIN(f₂)) in der vertikalen Richtung in verschiedenen Schichten des Trägersubstrats gestapelt und vertikal an der besagten Eingangsanschlussfahne (TRL_{IN}) angeschlossen werden;
wenn eine Breite der besagten Mehrzahl von RF-Signalausgangsanpassungsleitungen (ℓOUT(f₀), ℓOUT(f₁), ℓOUT(f₂)) in einer seitlichen Richtung des besagten Trägersubstrats gleich einer oder kleiner als eine seitliche Breite der besagten RF-Ausgangsanschlussfahne (TRL_{OUT}) des besagten Transistors (TR) ist, die mehrfachen Signalausgangsanpassungsleitungen (ℓOUT(f₀), ℓOUT(f₁), ℓOUT(f₂)) nebeneinander in der seitlichen Richtung auf einer gemeinsamen Schicht des Trägersubstrats angeordnet und nebeneinander an der besagten Ausgangsanschlussfahne (TRL_{OUT}) angeschlossen werden, und
wenn eine Breite der besagten Mehrzahl von RF-Signalausgangsanpassungsleitungen (ℓOUT(f₀), ℓOUT(f₁), ℓOUT(f₂)) in einer seitlichen Richtung des besagten Trägersubstrats größer als eine seitliche Breite der besagten RF-Ausgangsanschlussfahne (TRL_{OUT}) des besagten Transistors (TR) ist, die mehrfachen RF-Signalausgangsanpassungsleitungen (ℓOUT(f₀), ℓOUT(f₁), ℓOUT(f₂)) in der vertikalen Richtung in verschiedenen Schichten des Trägersubstrats gestapelt und vertikal an der besagten Ausgangsanschlussfahne (TRL_{OUT}) angeschlossen werden.

2. Die Verstärkeranordnung nach Anspruch 1, wobei
- das besagte RF-Eingangssignal eine erste und eine zweite Wellenlänge (λf₁, λf₂) aufweist;
- jeweils eine erste und eine zweite RF-Signaleingangsanpassungsleitung (ℓIN(f₁), ℓIN(f₂)) sowie eine erste und eine zweite RF-Signalausgangsanpassungsleitung (ℓOUT(f₁), ℓOUT(f₂)) bereitgestellt werden, wobei jede einzelne RF-Signaleingangsanpassungsleitung (ℓIN(f₁), ℓIN(f₂)) jeweils an zwei assoziierte λ/4-Blockiermittel (C₁₁, C₁₂, C₂₁, C₂₂), die jeweils für das Blockieren der entsprechenden RF-Signaleingangsleitung (ℓIN(f₂)) gegen entweder die besagte erste oder die besagte zweite Wellenlänge (λf₁, λf₂) des RF-Eingangssignals, an welches die entsprechende RF-Signaleingangsanpassungsleitung (ℓIN(f₁), ℓIN(f₂)) nicht angepasst ist, konfiguriert sind, gekoppelt ist, und wobei jede einzelne RF-Signalausgangsanpassungsleitung (ℓOUT(f₁), ℓOUT(f₂)) jeweils an zwei assoziierte λ/4-Blockiermittel (C₁₃, C₁₄, C₂₃, C₂₄), die jeweils für das Blockieren der entsprechenden RF-Signalausgangsleitung gegen entweder die besagte erste oder die besagte zweite Wellenlänge (λf₁, λf₂) des RF-Ausgangssignals, an welches die entsprechende RF-Signalausgangsanpassungsleitung (ℓOUT(f₁), ℓOUT(f₂)) nicht angepasst ist, konfiguriert sind, gekoppelt ist.

3. Die Verstärkeranordnung nach Anspruch 1, wobei
- das besagte RF-Eingangssignal drei verschiedene Wellenlängen (λf₀, λf₁, λf₂) aufweist;
- die besagte Mehrzahl von verzweigten einzelnen RF-Signaleingangsanpassungsleitungen eine erste, zweite und dritte RF-Signaleingangsanpassungsleitung (ℓIN(f₀), ℓIN(f₁), ℓIN(f₂)) umfasst und die besagte Mehrzahl von RF-Signalausgangsanpassungsleitungen (ℓOUT(f₀), ℓOUT(f₁), ℓOUT(f₂)) eine erste, zweite und dritte RF-Signalausgangsanpassungsleitung (ℓOUT(f₀) ℓOUT(f₁), ℓOUT(f₂)) umfasst;
- zwei erste und zwei zweite λ/4-Blockiermittel an die besagte erste RF-Signaleingangsanpassungsleitung (ℓIN(f₁) gekoppelt und für das Blockieren gegen die zweite und dritte Wellenlänge (λf₁, λf₂) der besagten Wellenlängen (λf₀, λf₁, λf₂) des besagten RF-Eingangssignals konfiguriert sind;
- zwei dritte und zwei vierte λ/4-Blockiermittel an die besagte zweite RF-Signaleingangsanpassungsleitung (ℓIN(f₁) gekoppelt und für das Blockieren gegen die erste und dritte Wellenlänge (λf₀, λf₂) der besagten Wellenlängen (λf₀, λf₁, λf₂) des besagten RF-Eingangssignals konfiguriert sind;
- zwei fünfte und zwei sechste λ/4-Blockiermittel an die besagte dritte RF-Signaleingangsanpassungsleitung (ℓIN(f₂)) gekoppelt und für die Blockierung gegen die erste und zweite Wellenlänge (λf₀, λf₁ der besagten Wellenlängen (λf₀, λf₁, λf₂) des besagten RF-Eingangssignals konfiguriert sind;
- zwei erste und zwei zweite λ/4-Blockiermittel an die besagte erste RF-Signalausgangsanpassungsleitung (ℓOUT(f₁)) gekoppelt und für die Blockierung gegen die zweite und dritte Wellenlänge (λf₁, λf₂) der besagten Wellenlängen (λf₀, λf₁, λf₂) des besagten RF-Ausgangssignals konfiguriert sind;
- zwei dritte und zwei vierte λ/4-Blockiermittel an die besagte zweite RF-Signalausgangsanpassungsleitung (ℓOUT(f₂)) gekoppelt und für die Blockierung gegen die erste und dritte Wellenlänge (λf₀, λf₂) der besagten Wellenlängen (λf₀, λf₁, λf₂) des besagten RF-Ausgangssignals konfiguriert sind, und
- zwei fünfte und zwei sechste λ/4-Blockiermittel an die besagte dritte RF-Signalausgangsanpassungsleitung (ℓOUT(f₂)) gekoppelt und für die Blockierung gegen die erste und zweite Wellenlänge (λf₀, λf₁) der besagten Wellenlängen (λf₀, λf₁, λf₂) des besagten RF-Ausgangssignals konfiguriert sind.

4. Die Verstärkeranordnung nach Anspruch 1, wobei
- das besagte RF-Eingangssignal eine erste, zweite und dritte Wellenlänge (λf₀, λf₁, λf₂) umfasst;
- die besagte Mehrzahl von verzweigten einzelnen RF-Signaleingangsanpassungsleitungen eine erste und eine zweite RF-Signaleingangsanpassungsleitung (ℓIN(f₀,f₁), ℓIN(f₂)) umfasst, und die besagte Mehrzahl von RF-Signalausgangsanpassungsleitungen eine erste und eine zweite RF-Signalausgangsanpassungsleitung (ℓOUT(f₀,f₁), ℓOUT(f₂)) umfasst;
- die besagte erste RF-Signaleingangsanpassungsleitung (ℓIN(f₀,f₁)) und die besagte erste RF-Signalausgangsanpassungsleitung (ℓOUT(f₀f₁)) beide an die besagte erste und die besagte zweite Wellenlänge (λf₀, λf₁) des besagten RF-Signals angepasst und jeweils an zwei erste λ/4-Blockiermittel (C₁₁ bis C₁₄), welche für die Blockierung gegen die dritte Wellenlänge (λf₂) des besagten RF-Eingangssignals konfiguriert sind, gekoppelt sind;
- die besagte zweite RF-Signaleingangsanpassungsleitung (ℓIN(f₂)) und die besagte zweite RF-Signalausgangsanpassungsleitung (ℓOUT(f₂)) beide an die besagte dritte Wellenlänge (λf₂) des besagten RF-Signals angepasst und jeweils an zwei zweite und zwei dritte λ/4-Blockiermittel (C₂₂ bis C₂₉), welche jeweils für die Blockierung gegen die erste und die zweite Wellenlänge (λf₀, λf₁) des RF-Signals konfiguriert sind, gekoppelt sind.

5. Verfahren zur Verstärkung eines RF-Eingangssignals mit einer Mehrzahl von verschiedenen Wellenlängen (λf₀, λf₁, λf₂), wobei das Verfahren die folgenden Schritte umfasst:
- Verteilen des besagten RF-Eingangssignals durch Verzweigen einer gemeinsamen RF-Signaleingangsleitung (ℓ₁), welche das besagte RF-Eingangssignal empfängt, in eine Mehrzahl von einzelnen RF-Signaleingangsanpassungsleitungen (ℓIN(f₀), ℓIN(f₁), ℓIN(f₂)), und gemeinsames Anschließen der besagten einzelnen RF-Signaleingangsanpassungsleitungen (ℓIN(f₀), ℓIN(f₁), ℓIN(f₂)) an einen Eingangsanschluss (TRL_{IN}) einer RF-Leistungsverstärkerkomponente (TR), wobei jede einzelne RF-Signaleingangsanpassungsleitung (ℓIN(f₀), ℓIN(f₁), ℓIN(f₂)) separat an eine entsprechende der verschiedenen Wellenlängen (λf₀, λf₁, λf₂) des RF-Eingangssignals angepasst und jede einzelne RF-Signaleingangsanpassungsleitung (ℓIN(f₀), ℓIN(f₁), ℓIN(f₂)) gegen die anderen Wellenlängen (λf₀, λf₁, λf₂) des besagten RF-Eingangssignals blockiert wird;
- Anschließen einer Mehrzahl von einzelnen RF-Signalausgangsanpassungsleitungen (ℓOUT(f₀), ℓOUT(f₁), ℓOUT(f₂)) gemeinsam an einen Ausgangsanschluss (TRL_{OUT}) der besagten Verstärkerkomponente (TR), wobei jede einzelne RF-Signalausgangsanpassungsleitung (ℓOUT(f₀), ℓOUT(f₁), ℓOUT(f₂)) separat an eine entsprechende der verschiedenen Wellenlängen (λf₀, λf₁, λf₂) eines RF-Ausgangssignals angepasst und jede einzelne RF-Signalausgangsanpassungsleitung (ℓOUT(f₀), ℓOUT(f₁), ℓOUT(f₂)) gegen die anderen der besagten Wellenlängen (λf₀, λf₁, λf₂) des besagten RF-Ausgangssignals blockiert wird; und
- Verbinden der Mehrzahl der RF-Signalausgangsanpassungsleitungen (ℓOUT(f₀), ℓOUT(f₁), ℓOUT(f₂)) an deren dem besagten Ausgangsanschluss (TRL_{OUT}) der besagten RF-Verstärkerkomponente (TR) gegenüberliegenden Enden für den Anschluss an eine gemeinsame RF-Signalausgangsanpassungsleitung (ℓOUT(f₀), ℓOUT(f₁), ℓOUT(f₂)) für die Ausgabe der verstärkten RF-Ausgangssignals mit der besagten Mehrzahl von verschiedenen Wellenlängen (λf₀, λf₁, λf₂), wobei die besagte Mehrzahl von verzweigten einzelnen RF-Signaleingangsanpassungsleitungen (ℓIN(f₀), ℓIN(f₁), ℓIN(f₂)) und die besagte Mehrzahl von einzelnen RF-Signalausgangsanpassungsleitungen (ℓOUT(f₀), ℓOUT(f₁), ℓOUT(f₂)) jeweils als Streifenleitungen auf einem Trägersubstrat konfiguriert sind,
**dadurch gekennzeichnet, dass**
das besagte Blockieren unter Verwendung von λ/4-Blockiermittel ausgeführt wird, welche jeweils als eine kapazitive Leitung (C₁₁ to C₁₄; C₂₁ bis C₂₉), die für die Erdung verzweigt wird, um die besagte mindestens eine Wellenlänge (λf₀, λf₁, λf₂) des jeweiligen besagten RF-Eingangs- und des besagten RF-Ausgangssignals, gegen welche die besagte entsprechende RF-Signaleingangs- und - Signalausgangsanpassungsleitung (ℓIN(f₀), ℓIN(f₁), ℓIN(f₂)), (ℓOUT(f₀), ℓOUT(f₁), ℓOUT(f₂)) blockiert werden soll, kurzzuschließen, konfiguriert sind, wobei die besagte RF-Breitbandverstärkerkomponente (TR) als ein Transistor mit einer streifenleitungskompatiblen Konfiguration jeweils mit Anschlussfahnen als RF-Eingangs- und -Ausgangsanschlüsse (TRL_{IN}, TRL_{OUT}), eingesetzt wird; wobei das Verfahren weiterhin umfasst:
Wenn eine Breite der besagten Mehrzahl von RF-Signaleingangsanpassungsleitungen (ℓIN(f₀), (ℓIN(f₁), ℓIN(f₂)) in einer seitlichen Richtung des besagten Trägersubstrats gleich einer oder kleiner als eine seitliche Breite der besagten RF-Eingangsanschlussfahne (TRL_{IN}) des besagten Transistors (TR) ist, Anordnen der Mehrzahl der RF-Signaleingangsanpassungsleitungen (ℓIN(f₀), ℓIN(f₁), ℓIN(f₂)) nebeneinander in der seitlichen Richtung auf einer gemeinsamen Schicht des Trägersubstrats, und Anschließen der besagten RF-Signaleingangsanpassungsleitungen (ℓIN(f₀), ℓIN(f₁), ℓIN(f₂)) nebeneinander an der besagten Eingangsanschlussfahne (TRL_{IN});
wenn eine Breite der besagten RF-Signaleingangsanpassungsleitungen (ℓIN(f₀), ℓIN(f₁), ℓIN(f₂)) in einer seitlichen Richtung des besagten Trägersubstrats größer als eine seitliche Breite der besagten RF-Eingangsanschlussfahne (TRL_{IN}) des besagten Transistors (TR) ist, Stapeln der mehrfachen RF-Signaleingangsanpassungsleitungen (ℓIN(f₀), ℓIN(f₁), ℓIN(f₂)) in der vertikalen Richtung in verschiedenen Schichten des Trägersubstrats und vertikales Anschließen der besagten Signaleingangsanpassungsleitungen (ℓIN(f₀), ℓIN(f₁), ℓIN(f₂)) an der besagten Eingangsanschlussfahne (TRL_{IN});
wenn eine Breite der besagten Mehrzahl von RF-Signalausgangsleitungen (ℓOUT(f₀), ℓOUT(f₁), ℓOUT(f₂)) in einer seitlichen Richtung des besagten Trägersubstrats gleich einer oder kleiner als eine seitliche Breite des besagten RF-Ausgangsanschlussfahne (TRL_{OUT}) des besagten Transistors (TR) ist, Anordnen der mehrfachen RF-Signalausgangsanpassungsleitungen (ℓOUT(f₀), ℓOUT(f₁), ℓOUT(f₂)) nebeneinander in der seitlichen Richtung auf einer gemeinsamen Schicht des Trägersubstrats, und Anschließen der besagten Signalausgangsanpassungsleitungen (ℓOUT(f₀), ℓOUT(f₁), ℓOUT(f₂)) nebeneinander an der besagten Ausgangsanschlussfahne (TRL_{OUT}), und
wenn eine Breite der besagten Mehrzahl von RF-Signalausgangsanpassungsleitungen (ℓOUT(f₀), ℓOUT(f₁), ℓOUT(f₂)) in einer seitlichen Richtung des besagten Trägersubstrats größer als eine seitliche Breite der besagten RF-Ausgangsanschlussfahne (TRL_{OUT}) des besagten Transistors (TR) ist, Stapeln der mehrfachen RF-Signalausgangsanpassungsleitungen (ℓOUT(f₀), ℓOUT(f₁), ℓOUT(f₂)) in der vertikalen Richtung in verschiedenen Schichten des Trägersubstrats, und vertikales Anschließen der besagten RF-Signalausgangsanpassungsleitungen (ℓOUT(f₀), ℓOUT(f₁), ℓOUT(f₂)) an der besagten Ausgangsanschlussfahne (TRL_{OUT}).

6. Das Verfahren nach Anspruch 5, wobei
das besagte RF-Eingangssignal eine erste und eine verschiedene zweite Wellenlänge (λf₁, λf₂) hat und das Verfahren weiterhin umfasst:
- Verzweigen der besagten gemeinsamen RF-Signaleingangsleitung (ℓ₁) in eine erste und eine zweite RF-Signaleingangsanpassungsleitung (ℓIN(f₁), ℓIN(f₂)), und wobei die besagte Mehrzahl von RF-Signalausgangsanpassungsleitungen (ℓOUT(f₀), ℓOUT(f₁), ℓOUT(f₂)) eine erste und eine zweite RF-Signalausgangsanpassungsleitung (ℓOUT(f₁), ℓOUT(f₂)) umfasst, und separates Anpassen der besagten ersten und der besagten zweiten RF-Signaleingangs- und -Signalausgangsanpassungsleitungen ℓIN(f₁), ℓIN(f₂), ℓOUT(f₁), ℓOUT(f₂)) an die besagte erste und die besagte zweite Wellenlänge (λf₁, λf₂) des jeweiligen besagten RF-Eingangs- und -Ausgangssignals;
- Blockieren der besagten ersten RF-Signaleingangsanpassungsleitung (ℓIN(f₁)) gegen die zweite Wellenlänge (λf₂) des besagten RF-Eingangssignals;
- Blockieren der besagten zweiten RF-Signaleingangsanpassungsleitung (ℓIN(f₂)) gegen die erste Wellenlänge (λf₁) des besagten RF-Eingangssignals;
- Blockieren der besagten ersten RF-Signalausgangsanpassungsleitung (ℓOUT(f₁)) gegen die zweite Wellenlänge (λf₂) des besagten RF-Ausgangssignals, und
- Blockieren der besagten zweiten RF-Signalausgangsanpassungsleitung (ℓOUT(f₂)) gegen die erste Wellenlänge (λf₁) des besagten RF-Ausgangssignals.

7. Das Verfahren nach Anspruch 5, wobei
- das besagte RF-Eingangssignal verschiedene erste, zweite und dritte Wellenlängen (λf₀, λf₁, λf₂) hat, und das Verfahren weiterhin umfasst:
- Verzweigen der besagten gemeinsamen RF-Signaleingangsleitung (ℓ₁) in eine erste, zweite und dritte RF-Signaleingangsanpassungsleitung (ℓIN(f₀), ℓIN(f₁), ℓIN(f₂)), und wobei die besagte Mehrzahl von RF-Signalsausgangsleitungen eine erste, zweite und dritte RF-Signalausgangsanpassungsleitung (ℓOUT(f₀), ℓOUT(f₁), ℓOUT(f₂)) umfasst;
- Blockieren der besagten RF-Signaleingangsanpassungsleitung (ℓIN(f₀)) gegen die zweite und dritte Wellenlänge (λf₁, λf₂) der besagten Wellenlängen (λf₀, λf₁, λf₂) des besagten RF-Eingangssignals;
- Blockieren der besagten zweiten RF-Signaleingangsanpassungsleitung (ℓIN(f₁)) gegen die erste und dritte Wellenlänge (λf₀, λf₂) der besagten Wellenlängen (λf₀, λf₁, λf₂) des besagten RF-Eingangssignals;
- Blockieren der besagten dritten RF-Signaleingangsanpassungsleitung (ℓIN(f₂)) gegen die erste und zweite Wellenlänge (λf₀, λf₁) der besagten Wellenlängen (λf₀, λf₁, λf₂) des besagten RF-Eingangssignals;
- Blockieren der besagten ersten RF-Signalausgangsanpassungsleitung (ℓOUT(f₀)) gegen die zweite und dritte Wellenlänge (λf₁, λf₂) der besagten Wellenlängen (λf₀, λf₁, λf₂) des besagten RF-Ausgangssignals;
- Blockieren der besagten zweiten RF-Signalausgangsanpassungsleitung (ℓOUT(f₁)) gegen die erste und dritte Wellenlänge (λf₀, λf₂) der besagten Wellenlängen (λf₀, λf₁, λf₂) des besagten RF-Ausgangssignals, und
- Blockieren der besagten dritten RF-Signalausgangsanpassungsleitung (ℓOUT(f₂)) gegen die erste und zweite Wellenlänge (λf₀, λf₁) der besagten Wellenlängen (λf₀, λf₁, λf₂) des besagten RF-Ausgangssignals.

8. Basisstation für ein zellulares Kommunikationsnetzwerk, welches die besagte Verstärkeranordnung (1) gemäß Anspruch 1 einsetzt.

9. Kommunikationsnetzwerk eines zellularen Kommunikationssystems, welches die besagte Verstärkeranordnung (1) gemäß Anspruch 1 einsetzt.

10. Computerprogramm-Produkt mit Codemitteln zum Ausführen der Schritte gemäß Anspruch 5.

## Revendications

1. Agencement d'amplificateur (1) adapté pour l'amplification d'un signal d'entrée RF présentant une pluralité de longueurs d'onde différentes (λf₀, λf₁, λf₂) et étant entré à travers des lignes d'entrée différentes en série ou en parallèle, ledit agencement d'amplificateur (1) comprenant :
- un composant d'amplificateur à large bande RF (TR) présentant une borne d'entrée (TRL_{IN}) et une borne de sortie (TRL_{OUT}),
- une ligne commune d'entrée de signal RF (ℓ_{I}) étant disposée pour recevoir ledit signal d'entrée RF et pour se ramifier en une pluralité de lignes d'adaptation d'entrée de signal RF uniques connectées en commun à la borne d'entrée (TRL_{IN}) dudit composant d'amplificateur RF (TR), et chaque ligne d'adaptation d'entrée de signal RF unique (ℓIN(f₀), ℓIN(f₁), ℓIN(f₂)) formant un réseau d'adaptation d'entrée de signal RF configuré pour adapter ladite ligne d'adaptation d'entrée de signal RF unique à au moins une desdites longueurs d'onde (λf₀, λf₁, λf₂) traversant ladite ligne d'adaptation d'entrée de signal RF unique (ℓIN(f₀), ℓIN(f₁), ℓIN(f₂)), dans lequel chaque ligne d'adaptation d'entrée de signal RF unique (ℓIN(f₀), ℓIN(f₁), ℓIN(f₂)) au niveau de son point de ramification et au niveau de sa connexion à la borne d'entrée (TRL_{IN}) dudit amplificateur RF, est respectivement couplée à des moyens de blocage λ/4 (C₁₁, C₁₂, C₂₁ à C₂₅) pour bloquer contre une ou plusieurs longueurs d'onde (λf₀, λf₁, λf₂) dudit signal d'entrée RF auxquelles ladite ligne d'adaptation d'entrée de signal RF respective (ℓIN(f₀), ℓIN(f₁), ℓIN(f₂) n'est pas adaptée ; et
- une pluralité de lignes d'adaptation de sortie de signal RF (ℓOUT(f₀), ℓOUT(f₁), ℓOUT(f₂)) étant connectées en commun à la borne de sortie (TRL_{OUT}) dudit composant d'amplificateur (TR), et chaque ligne d'adaptation de sortie de signal RF unique (ℓOUT(f₀), ℓOUT(f₁), ℓOUT(f₂)) formant un réseau d'adaptation de sortie de signal RF configuré pour adapter ladite ligne d'adaptation de sortie de signal RF unique (ℓOUT(f₀), ℓOUT(f₁), ℓOUT(f₂)) à au moins une desdites longueurs d'onde (λf₀, λf₁, λf₂) traversant ladite ligne d'adaptation de sortie de signal RF unique (ℓOUT(f₀), ℓOUT(f₁), ℓOUT(f₂)), et la pluralité des lignes d'adaptation de sortie de signal RF (ℓOUT(f₀), ℓOUT(f₁), ℓOUT(f₂)) étant connectée ensemble au niveau de leurs extrémités opposées à ladite borne de sortie (TRL_{OUT}) dudit composant d'amplificateur RF (TR) pour devenir une ligne commune de sortie de signal RF (ℓ₀) pour délivrer en sortie le signal de sortie RF amplifié présentant ladite pluralité de longueurs d'onde différentes (λf₀, λf₁, λf₂), dans lequel chaque ligne d'adaptation de sortie de signal RF unique (ℓOUT(f₀), ℓOUT(f₁), ℓOUT(f₂)) au niveau de son point de connexion à la borne de sortie (TRL_{OUT}) dudit composant d'amplificateur RF (TR) et au niveau de son point de connexion aux autres lignes d'adaptation de sortie de signal RF (ℓOUT(f₀), ℓOUT(f₁), ℓOUT(f₂)) est respectivement couplée à des moyens de blocage λ/4 (C₁₃, C₁₄, C₂₃, C₂₄, C₂₆ à C₂₉) pour bloquer contre une ou plusieurs longueurs d'onde (λf₀, λf₁, λf₂) dudit signal de sortie RF auxquelles ladite ligne d'adaptation de sortie de signal RF respective (ℓOUT(f₀), ℓOUT(f₁), ℓOUT(f₂)) n'est pas adaptée, ladite pluralité de lignes d'adaptation d'entrée de signal RF unique ramifiées (ℓIN(f₀), ℓIN(f₁), ℓIN(f₂)) et ladite pluralité de lignes d'adaptation de sortie de signal RF unique (ℓOUT(f₀), ℓOUT(f₁), ℓOUT(f₂)) sont toutes configurées comme des lignes à ruban sur un substrat de support,
**caractérisé en ce que**
lesdits moyens de blocage λ/4 sont tous configurés comme une ligne capacitive (C₁₁ à C₁₄ ; C₂₁ à C₂₉) reliée à la terre pour court-circuiter ladite au moins une longueur d'onde (λf₀, λf₁, λf₂) dudit signal d'entrée et de sortie RF, respectivement, contre laquelle ladite ligne d'adaptation d'entrée et de sortie de signal RF respective (ℓIN(f₀), ℓIN(f₁), ℓIN(f₂)), (ℓOUT(f₀), ℓOUT(f₁), ℓOUT(f₂)) doit être bloquée, ledit composant d'amplificateur à large bande RF (TR) est mis en oeuvre comme un transistor présentant une configuration compatible avec des lignes à ruban avec des cosses de borne en tant que bornes d'entrée et de sortie RF (TRL_{IN}, TRL_{OUT}), respectivement ; dans lequel
dans le cas où une largeur de ladite pluralité de lignes d'adaptation d'entrée de signal RF (ℓIN(f₀), ℓIN(f₁), ℓIN(f₂)) dans un sens latéral dudit substrat de support est égale ou inférieure à une largeur latérale de ladite cosse de borne d'entrée RF (TRL_{IN}) dudit transistor (TR), la pluralité de lignes d'adaptation d'entrée de signal RF (ℓIN(f₀), ℓIN(f₁), ℓIN(f₂)) sont disposées côte à côte dans le sens latéral sur une couche commune du substrat de support et sont connectées côte à côte à ladite cosse de borne d'entrée (TRL_{IN}),
dans le cas où une largeur desdites lignes d'adaptation d'entrée de signal RF (ℓIN(f₀), ℓIN(f₁), ℓIN(f₂)) dans un sens latéral dudit substrat de support est supérieure à une largeur latérale de ladite cosse de borne d'entrée RF (TRL_{IN}) dudit transistor (TR), la pluralité de lignes d'adaptation d'entrée de signal RF (ℓIN(f₀), ℓIN(f₁), ℓIN(f₂)) sont empilées dans le sens vertical sur des couches différentes du substrat de support et sont connectées verticalement à ladite cosse de borne d'entrée (TRL_{IN}) ;
dans le cas où une largeur de ladite pluralité de lignes d'adaptation de sortie de signal RF (-ℓOUT(f₀), ℓOUT(f₁), ℓOUT(f₂)) dans un sens latéral dudit substrat de support est égale ou inférieure à une largeur latérale de ladite cosse de borne de sortie RF (TRL_{OUT}) dudit transistor (TR), la pluralité de lignes d'adaptation de sortie de signal (ℓOUT(f₀), ℓOUT(f₁), ℓOUT(f₂)) sont disposées côte à côte dans le sens latéral sur une couche commune du substrat de support et sont connectées côte à côte à ladite cosse de borne de sortie (TRL_{OUT}), et
dans le cas où une largeur de ladite pluralité de lignes d'adaptation de sortie de signal RF (ℓOUT(f₀), ℓOUT(f₁), ℓOUT(f₂)) dans un sens latéral dudit substrat de support est supérieure à une largeur latérale de ladite cosse de borne de sortie RF (TRL_{OUT}) dudit transistor (TR), la pluralité de lignes d'adaptation de sortie de signal RF (ℓOUT(f₀), ℓOUT(f₁), ℓOUT(f₂)) sont empilées dans le sens vertical sur des couches différentes du substrat de support et sont connectées verticalement à ladite cosse de borne de sortie (TRL_{OUT}).

2. Agencement d'amplificateur selon la revendication 1, dans lequel :
- ledit signal d'entrée RF présente une première et une deuxième longueurs d'onde (λf₁, _{λ}f₂) ;
- une première et une deuxième lignes d'adaptation d'entrée de signal RF (ℓIN(f₁), ℓIN(f₂)) et une première et une deuxième lignes d'adaptation de sortie de signal RF (ℓOUT(f₁), ℓOUT(f₂)) sont respectivement prévues, chaque ligne d'adaptation d'entrée de signal RF unique (ℓIN(f₁), ℓIN(f₂)) étant respectivement couplée à deux moyens de blocage λ/4 associés (C₁₁, C₁₂, C₂₁, C₂₂) chacun étant configuré pour bloquer la ligne d'entrée de signal RF respective (ℓIN(f₁), (ℓIN(f₂)) contre une desdites première et deuxième longueurs d'onde (λf₁, λf₂) du signal d'entrée RF auxquelles la ligne d'adaptation d'entrée de signal RF respective (ℓIN(f₁), ℓIN(f₂)) n'est pas adaptée, et chaque ligne d'adaptation de sortie de signal RF unique (ℓOUT(f₁), ℓOUT(f₂)) étant respectivement couplée à deux moyens de blocage λ/4 associés (C₁₃, C₁₄, C₂₃, C₂₄) chacun étant configuré pour bloquer la ligne de sortie de signal RF respective contre une desdites première et deuxième longueurs d'onde (λf₁, λf₂) du signal de sortie RF auxquelles ladite ligne d'adaptation de sortie de signal RF respective (ℓOUT(f₁), ℓOUT(f₂)) n'est pas adaptée.

3. Agencement d'amplificateur selon la revendication 1, dans lequel :
- ledit signal d'entrée RF présente trois longueurs d'onde différentes (λf₀, λf₁, λf₂) ;
- ladite pluralité de lignes d'adaptation d'entrée de signal RF unique ramifiées comprend une première, une deuxième et une troisième lignes d'adaptation d'entrée de signal RF (ℓIN(f₀), ℓIN(f₁), ℓIN(f₂)) et ladite pluralité de lignes d'adaptation de sortie de signal RF (ℓOUT(f₀), ℓOUT(f₁), ℓOUT(f₂)) comprend une première, une deuxième et une troisième lignes d'adaptation de sortie de signal RF (ℓOUT(f₀) ℓOUT(f₁), ℓOUT(f₂)) ;
- deux premiers et deux deuxièmes moyens de blocage λ/4 sont couplés à ladite première ligne d'adaptation d'entrée de signal RF (ℓIN(f₀) et configurés pour bloquer contre les deuxième et troisième longueurs d'onde (λf₁, λf₂) parmi lesdites longueurs d'onde (λf₀, λf₁, λf₂) dudit signal d'entrée RF ;
- deux troisièmes et deux quatrièmes moyens de blocage λ/4 sont couplés à ladite deuxième ligne d'adaptation d'entrée de signal RF (ℓIN(f₁) et configurés pour bloquer contre les première et troisième longueurs d'onde (λf₀, λf₂) desdites longueurs d'onde (λf₀, λf₁, λf₂) dudit signal d'entrée RF ;
- deux cinquièmes et deux sixièmes moyens de blocage λ/4 sont couplés à ladite troisième ligne d'entrée de signal RF (ℓIN(f₂) et configurés pour bloquer contre les première et deuxième longueurs d'onde (λf₀, λf₁) desdites longueurs d'onde (λf₀, λf₁, λf₂) dudit signal d'entrée RF ;
- deux premiers et deux deuxièmes moyens de blocage λ/4 sont couplés à ladite première ligne d'adaptation de sortie de signal RF (ℓOUT(f₀) et configurés pour bloquer contre les deuxième et troisième longueurs d'onde (λf₁, λf₂) parmi lesdites longueurs d'onde (λf₀, λf₁, λf₂) dudit signal de sortie RF ;
- deux troisièmes et deux quatrièmes moyens de blocage λ/4 sont couplés à ladite deuxième ligne d'adaptation de sortie de signal RF (ℓOUT(f₁) et configurés pour bloquer contre les première et troisième longueurs d'onde (λf₀, λf₂) parmi lesdites longueurs d'onde (λf₀, λf₁, λf₂) dudit signal de sortie RF, et
- deux cinquièmes et deux sixièmes moyens de blocage λ/4 sont couplés à ladite troisième ligne d'adaptation de sortie de signal RF (ℓOUT(f₂) et configurés pour bloquer contre les première et deuxième longueurs d'onde (λf₀, λf₁) parmi lesdites longueurs d'onde (λf₀, λf₁, λf₂) dudit signal de sortie RF.

4. Agencement d'amplificateur selon la revendication 1, dans lequel :
- ledit signal d'entrée RF comprend une première, une deuxième et une troisième longueurs d'onde (λf₀, λf₁, λf₂) ;
- ladite pluralité de lignes d'adaptation d'entrée de signal RF unique ramifiées comprend une première et une deuxième lignes d'adaptation d'entrée de signal RF (ℓIN(f₀, f₁), ℓIN(f₂)) et ladite pluralité de lignes d'adaptation de sortie de signal RF comprend une première et une deuxième lignes d'adaptation de sortie de signal RF (ℓOUT(f₀, f₁), ℓOUT(f₂)) ;
- ladite première ligne d'adaptation d'entrée de signal RF (ℓIN(f₀, f₁)) et ladite première ligne d'adaptation de sortie de signal RF (ℓOUT(f₀, f₁)) sont toutes les deux adaptées auxdites première et deuxième longueurs d'onde (λf₀, λf₁) dudit signal RF et sont toutes couplées à deux premiers moyens de blocage λ/4 (C₁₁ à C₁₄) configurés pour bloquer contre la troisième longueur d'onde (λf₂) dudit signal d'entrée RF ;
- ladite deuxième ligne d'adaptation d'entrée de signal RF (ℓIN(f₂)) et ladite deuxième ligne d'adaptation de sortie de signal RF (ℓOUT(f₂)) sont toutes les deux adaptées à ladite troisième longueur d'onde (λf₂) dudit signal RF et sont toutes couplées à deux deuxièmes et deux troisièmes moyens de blocage λ/4 (C₂₂ à C₂₉) chacun étant configuré pour bloquer contre les première et deuxième longueurs d'onde (λf₀, λf₁) du signal RF.

5. Procédé d'amplification d'un signal d'entrée RF présentant une pluralité de longueurs d'onde différentes (λf₀, λf₁, λf₂), ledit procédé comprenant les étapes suivantes :
- distribuer ledit signal d'entrée RF en ramifiant une ligne commune d'entrée de signal RF (ℓ₁) qui reçoit ledit signal d'entrée RF en une pluralité de lignes d'adaptation d'entrée de signal RF unique (ℓIN(f₀), ℓIN(f₁), ℓIN(f₂)) et en connectant lesdites lignes d'adaptation d'entrée de signal RF unique (ℓIN(f₀), ℓIN(f₁), ℓIN(f₂)) en commun à une borne d'entrée (TRL_{IN}) d'un composant d'amplificateur de puissance RF (TR), adapter séparément chaque ligne d'adaptation d'entrée de signal RF unique (ℓIN(f₀), ℓIN(f₁), ℓIN(f₂)) à une longueur d'onde respective des longueurs d'onde différentes (λf₀, λf₁, λf₂) du signal d'entrée RF et bloquer chaque ligne d'adaptation d'entrée de signal RF unique (ℓIN(f₀), ℓIN(f₁), ℓIN(f₂)) contre les autres longueurs d'onde (λf₀, λf₁, λf₂) dudit signal d'entrée RF ;
- connecter une pluralité de lignes d'adaptation de sortie de signal RF unique (ℓOUT(f₀), ℓOUT(f₁), ℓOUT(f₂)) en commun à une borne de sortie (TRL_{OUT}) dudit composant d'amplificateur (TR), adapter séparément chaque ligne de sortie de signal RF unique (ℓOUT(f₀), ℓOUT(f₁), ℓOUT(f₂)) à une longueur d'onde respective des longueurs d'onde différentes (λf₀, λf₁, λf₂) d'un signal de sortie RF et bloquer chaque ligne de sortie de signal RF unique (ℓOUT(f₀), ℓOUT(f₁), ℓOUT(f₂)) contre les autres parmi lesdites longueurs d'onde (λf₀, λf₁, λf₂) dudit signal de sortie RF ; et
- connecter ensemble la pluralité des lignes d'adaptation de sortie de signal RF (ℓOUT(f₀), ℓOUT(f₁), ℓOUT(f₂)) au niveau de leurs extrémités opposées à ladite borne de sortie (TRL_{OUT}) dudit composant d'amplificateur RF (TR) à une ligne commune de sortie de signal RF (ℓOUT(f₀), ℓOUT(f₁), ℓOUT(f₂)) pour délivrer en sortie le signal de sortie RF amplifié présentant ladite pluralité de longueurs d'onde différentes (λf₀, λf₁, λf₂), ladite pluralité de lignes d'adaptation d'entrée de signal RF unique ramifiées (ℓIN(f₀), ℓIN(f₁), ℓIN(f₂)) et ladite pluralité de lignes d'adaptation de sortie de signal RF unique (ℓOUT(f₀), ℓOUT(f₁), ℓOUT(f₂)) sont toutes configurées comme des lignes à ruban sur un substrat de support,
**caractérisé en ce que**
ledit blocage est réalisé en utilisant des moyens de blocage λ/4 étant chacun configurés comme une ligne capacitive (C₁₁ à C₁₄ ; C₂₁ à C₂₉) reliée à la terre pour court-circuiter ladite au moins une longueur d'onde (λf₀, λf₁, λf₂) dudit signal d'entrée et de sortie RF, respectivement, contre laquelle ladite ligne d'adaptation d'entrée et de sortie de signal RF respective (ℓIN(f₀), ℓIN(f₁), ℓIN(f₂)), (ℓOUT(f₀), ℓOUT(f₁), ℓOUT(f₂)) doit être bloquée, dans lequel ledit composant d'amplificateur à large bande RF (TR) est mis en oeuvre comme un transistor présentant une configuration compatible avec des lignes à ruban avec des cosses de borne en tant que bornes d'entrée et de sortie RF (TRL_{IN}, TRL_{OUT}), respectivement ; dans lequel le procédé comprend en outre les étapes suivantes :
dans le cas où une largeur de ladite pluralité de lignes d'adaptation d'entrée de signal RF (ℓIN(f₀), ℓIN(f₁), ℓIN(f₂)) dans un sens latéral dudit substrat de support est égale ou inférieure à une largeur latérale de ladite cosse de borne d'entrée RF (TRL_{IN}) dudit transistor (TR), disposer la pluralité de lignes d'adaptation d'entrée de signal RF (ℓIN(f₀), ℓIN(f₁), ℓIN(f₂)) côte à côte dans le sens latéral sur une couche commune du substrat de support et les connecter côte à côte à ladite cosse de borne d'entrée (TRL_{IN}),
dans le cas où une largeur desdites lignes d'adaptation d'entrée de signal RF (ℓIN(f₀), ℓIN(f₁), ℓIN(f₂)) dans un sens latéral dudit substrat de support est supérieure à une largeur latérale de ladite cosse de borne d'entrée RF (TRL_{IN}) dudit transistor (TR), empiler la pluralité de lignes d'adaptation d'entrée de signal RF (ℓIN(f₀), ℓIN(f₁), ℓIN(f₂)) dans le sens vertical sur des couches différentes du substrat de support et les connecter verticalement à ladite cosse de borne d'entrée (TRL_{IN}) ;
dans le cas où une largeur de ladite pluralité de lignes d'adaptation de sortie de signal RF (ℓOUT(f₀), (ℓOUT(f₁), ℓOUT(f₂)) dans un sens latéral dudit substrat de support est égale ou inférieure à une largeur latérale de ladite cosse de borne de sortie RF (TRL_{OUT}) dudit transistor (TR), disposer la pluralité de lignes d'adaptation de sortie de signal (ℓOUT(f₀), ℓOUT(f₁), ℓOUT(f₂)) côte à côte dans le sens latéral sur une couche commune du substrat de support et les connecter côte à côte à ladite cosse de borne de sortie (TRL_{OUT}), et
dans le cas où une largeur de ladite pluralité de lignes d'adaptation de sortie de signal RF (ℓOUT(f₀), ℓOUT(f₁), ℓOUT(f₂)) dans un sens latéral dudit substrat de support est supérieure à une largeur latérale de ladite cosse de borne de sortie RF (TRL_{OUT}) dudit transistor (TR), empiler la pluralité de lignes d'adaptation de sortie de signal RF (ℓOUT(f₀), ℓOUT(f₁), ℓOUT(f₂)) dans le sens vertical sur des couches différentes du substrat de support et les connecter verticalement à ladite cosse de borne de sortie (TRL_{OUT}).

6. Procédé selon la revendication 5, dans lequel
ledit signal d'entrée RF présente une première longueur d'onde et une deuxième longueur d'onde différente (λf₁, λf₂), et le procédé comprend en outre :
- ramifier ladite ligne commune d'entrée de signal RF (ℓ₁) en une première et une deuxième lignes d'adaptation d'entrée de signal RF (ℓIN(f₁), ℓIN(f₂)), et ladite pluralité de lignes d'adaptation de sortie de signal RF (ℓOUT(f₁), ℓOUT(f₂)) comprend une première et une deuxième lignes d'adaptation de sortie de signal RF (ℓOUT(f₁), ℓOUT(f₂)), et adapter séparément lesdites première et deuxième lignes d'adaptation d'entrée et de sortie de signal RF ℓIN(f₁), ℓIN(f₂), ℓOUT(f₁), ℓOUT(f₂)) auxdites première et deuxième longueurs d'onde (λf₁, λf₂) dudit signal d'entrée et de sortie RF, respectivement ;
- bloquer ladite première ligne d'adaptation d'entrée de signal RF (ℓIN(f₁)) contre la deuxième longueur d'onde (λf₂) dudit signal d'entrée RF ;
- bloquer ladite deuxième ligne d'adaptation d'entrée de signal RF (ℓIN(f₂)) contre la première longueur d'onde (λf₁) dudit signal d'entrée RF ;
- bloquer ladite première ligne d'adaptation de sortie de signal RF (ℓOUT(f₁)) contre la deuxième longueur d'onde (λf₂) dudit signal de sortie RF, et
- bloquer ladite deuxième ligne d'adaptation de sortie de signal RF (ℓOUT(f₂)) contre la première longueur d'onde (λf₁) dudit signal de sortie RF.

7. Procédé selon la revendication 5, dans lequel
- ledit signal d'entrée RF présente une première, une deuxième et une troisième longueurs d'onde (λf₀, λf₁, λf₂) différentes et le procédé comprend en outre :
- ramifier ladite ligne commune d'entrée de signal RF (ℓ₁) en une première, une deuxième et une troisième lignes d'adaptation d'entrée de signal RF (ℓIN(f₀), ℓIN(f₁), ℓIN(f₂)), et ladite pluralité de lignes de sortie de signal RF comprend une première, une deuxième et une troisième lignes d'adaptation de sortie de signal RF (ℓOUT(f₀), ℓOUT(f₁), ℓOUT(f₂)) ;
- bloquer ladite première ligne d'adaptation d'entrée de signal RF (ℓIN(f₀)) contre la deuxième et la troisième longueurs d'onde (λf₁, λf₂) parmi lesdites longueurs d'onde (λf₀, λf₁, λf₂) dudit signal d'entrée RF ;
- bloquer ladite deuxième ligne d'adaptation d'entrée de signal RF (ℓIN(f₁)) contre la première et la troisième longueurs d'onde (λf₀, λf₂) parmi lesdites longueurs d'onde (λf₀, λf₁, λf₂) dudit signal d'entrée RF ;
- bloquer ladite troisième ligne d'adaptation d'entrée de signal RF (ℓIN(f₂)) contre la première et la deuxième longueurs d'onde (λf₀, λf₁) parmi lesdites longueurs d'onde (λf₀, λf₁, λf₂) dudit signal d'entrée RF ;
- bloquer ladite première ligne d'adaptation de sortie de signal RF (ℓOUT(f₀)) contre la deuxième et la troisième longueurs d'onde (λf₁, λf₂) parmi lesdites longueurs d'onde (λf₀, λf₁, λf₂) dudit signal de sortie RF ;
- bloquer ladite deuxième ligne d'adaptation de sortie de signal RF (ℓOUT(f₁)) contre la première et la troisième longueurs d'onde (λf₀, λf₂) parmi lesdites longueurs d'onde (λf₀, λf₁, λf₂) dudit signal de sortie RF, et
- bloquer ladite troisième ligne d'adaptation de sortie de signal RF (ℓOUT(f₂)) contre la première et la deuxième longueurs d'onde (λf₀, λf₁) parmi lesdites longueurs d'onde (λf₀, λf₁, λf₂) dudit signal de sortie RF.

8. Station de base pour un réseau de communication cellulaire utilisant ledit agencement d'amplificateur (1) selon la revendication 1.

9. Réseau de communication d'un système de communication cellulaire utilisant ledit agencement d'amplificateur (1) selon la revendication 1.

10. Produit de programme informatique comprenant des moyens de code pour exécuter les étapes selon la revendication 5.
